# EUROPEAN PATENT APPLICATION

(11) **EP 4 852 644 A1**
(43) Date of publication of application: **09.12.2026**
(21) Application number: 26160597.6
(22) Date of filing: 25.02.2026
(51) Int. Cl.: H10B 43/10, H10B 43/20, H10B 43/35

(54) **SEMICONDUCTOR DEVICE AND ELECTRONIC SYSTEM INCLUDING THE SAME**

(30) Priority: 02.06.2025 KR 20250072204
(71) Applicant: Samsung Electronics Co., Ltd., Suwon-si, Gyeonggi-do 16677 (KR)
(72) Inventor: LEE, Haemin, Suwon-si (KR); CHUN, Sanghun, Suwon-si (KR); KANG, Seo-Goo, Suwon-si (KR); KANAMORI, Kohji, Suwon-si (KR); TAKAKI, Sejie, Suwon-si (KR); HAN, Jeehoon, Suwon-si (KR)
(74) Representative: Marks & Clerk LLP

(57) **Abstract**

A semiconductor device according to one example comprising: a plurality of channel stack structures, each including a plurality of interlayer insulating layers and a plurality of channel layers alternately stacked, the plurality of channel stack structures positioned spaced apart and arranged in a first direction; a first gate structure positioned between the plurality of channel stack structures; and a second gate structure positioned at one side of the first gate structure in a second direction intersecting the first direction, wherein the first gate structure includes: a first gate electrode; and a first charge storage layer surrounding the first gate electrode, wherein the second gate structure includes: a second gate electrode including a same material as a material of the first gate electrode; and a second charge storage layer surrounding the second gate electrode and including a same material as a material of the first charge storage layer, and wherein a width of the second gate structure in the second direction is greater than a width of the first gate structure in the second direction.

## Description

### FIELD

This disclosure relates to a semiconductor device and an electronic system including the same.

### BACKGROUND

A semiconductor is a material belonging to an intermediate region between a conductor and an insulator, and refers to a material through which electricity may flow under predetermined conditions. Various semiconductor devices may be manufactured using such semiconductor material, and for example, memory devices may be manufactured. A memory device may be classified into a volatile memory device and a non-volatile memory device. In the case of a non-volatile memory device, the contents may not be deleted even if the power is disconnected, and it may be used in various electronic devices including mobile phones, digital cameras, and PCs.

With the recent trend of increasing required storage capacity, improvement in the integration density of non-volatile memory devices may be needed. The integration density of memory devices arranged two-dimensionally on a plane may be limited. Accordingly, a vertical non-volatile memory device arranged in three dimensions is being proposed.

### SUMMARY

The examples are intended to provide a semiconductor device capable of preventing collapse of a plurality of channel stack structures and preventing defects, and an electronic system including the same.

A semiconductor device according to examples comprises: a plurality of channel stack structures, each including a plurality of interlayer insulating layers and a plurality of channel layers alternately stacked, the plurality of channel stack structures positioned spaced apart and arranged in a first direction; a first gate structure positioned between the plurality of channel stack structures; and a second gate structure positioned at one side of the first gate structure in a second direction intersecting the first direction, wherein the first gate structure includes: a first gate electrode; and a first charge storage layer surrounding the first gate electrode, wherein the second gate structure includes: a second gate electrode including a same material as a material of the first gate electrode; and a second charge storage layer surrounding the second gate electrode and including a same material as a material of the first charge storage layer, and wherein a width of the second gate structure in the second direction is greater than a width of the first gate structure in the second direction.

A semiconductor device according to examples comprises: a plurality of channel stack structures, each including a plurality of interlayer insulating layers and a plurality of channel layers alternately stacked, the plurality of channel stack structures positioned spaced apart and arranged in a first direction and extending in a second direction intersecting the first direction; a separation insulating layer positioned between the plurality of channel stack structures; a first gate structure positioned between the plurality of channel stack structures and penetrating the separation insulating layer; and a second gate structure positioned at one side of the first gate structure in the second direction and penetrating the separation insulating layer, wherein the first gate structure includes: a first gate electrode, and a first charge storage layer surrounding the first gate electrode, wherein the second gate structure includes: a second gate electrode including a same material as a material of the first gate electrode, and a second charge storage layer surrounding the second gate electrode and including a same material as a material of the first charge storage layer, and wherein a width of the separation insulating layer in a region adjacent to the first gate structure in the first direction is greater than a width of the separation insulating layer in a region adjacent to the second gate structure in the first direction.

A semiconductor device according to embodiments comprises: a main substrate; a semiconductor device on the main substrate; and a controller positioned on the main substrate and electrically connected to the semiconductor device, wherein the semiconductor device includes: a peripheral circuit region, a cell region including input/output connection wiring electrically connected to the peripheral circuit region, and an input/output pad positioned in the cell region and electrically connected to the input/output connection wiring extending into the cell region, wherein the cell region includes: a plurality of channel stack structures, each including a plurality of interlayer insulating layers and a plurality of channel layers alternately stacked and spaced apart and arranged in a first direction; a first gate structure positioned between the plurality of channel stack structures; and a second gate structure positioned at one side of the first gate structure in a second direction intersecting the first direction of the first gate structure, wherein the first gate structure includes: a first gate electrode; and a first charge storage layer surrounding the first gate electrode, wherein the second gate structure includes: a second gate electrode including a same material to that of the first gate electrode; and a second charge storage layer surrounding the second gate electrode and including a same material to that of the first charge storage layer, wherein a width of the second gate structure in the second direction is greater than a width of the first gate structure in the second direction.

A method of manufacturing a semiconductor device according to examples may include forming a preliminary stack structure by alternately stacking a plurality of interlayer insulating layers and a plurality of channel layers, forming a separation trench extending in a first direction and penetrating the preliminary stack structure to form a support portion, forming a separation insulating layer in the separation trench, forming a first hole penetrating the separation insulating layer and a second hole penetrating the support portion, and forming a first gate structure in the first hole and forming a second gate structure in the second hole, wherein a width of the first gate structure in the first direction is smaller than a width of the second gate structure in the first direction.

The step of forming the first gate structure includes a step of sequentially forming a first gate dielectric layer, a first gate electrode, and a first core insulating layer in the first hole, and the step of forming the second gate structure may include a step of sequentially forming a second gate dielectric layer, a second gate electrode, and a second core insulating layer in the second hole.

The second gate dielectric layer and the first gate dielectric layer may be formed simultaneously in the same process.

The support portion may be positioned at a central portion of the semiconductor device.

The second hole may be formed by etching at least a portion of the separation insulating layer.
the second hole may have a rounded rectangular shape in a plan view.

The contact area between the plurality of channel layers and the second gate structure may be greater than or equal to the contact area between the plurality of channel layers and the first gate structure.

The separation insulating layer includes a first portion positioned between the first gate structure and the second gate structure, and a side surface of the first portion may include a curved surface in a plan view.

The width in the second direction, which intersects the first direction of the first portion, may include a portion that decreases as a distance from the first gate structure increases.

A plurality of channel stack structures spaced apart and arranged in a second direction intersecting the first direction by the separation trench may be formed.

The separation insulating layer includes a first portion positioned between the first gate structure and the second gate structure, and the plurality of channel stack structures may include a protrusion portion recessed into a space between the first portion and the second gate structure.

The protrusion portion may be spaced apart from the first gate structure and may contact the second gate structure.

A semiconductor device according to embodiments may form a support portion between adjacent plurality of channel structures, and may form a second gate structure penetrating the support portion. Accordingly, in the process of manufacturing the semiconductor device, collapse of the plurality of channel stack structures may be prevented, and defects in the semiconductor device may be prevented.

At least some of the above and other features of the invention are set out in the claims.

### BRIEF DESCRIPTION OF THE DRAWINGS

FIG. 1 is a plan view showing a semiconductor device according to examples.
FIG. 2 is a cross-sectional view taken along A-A' of FIG. 1.
FIG. 3 is a cross-sectional view taken along B-B' of FIG. 1.
FIG. 4 is a plan view enlarging the Q1 region of FIG. 1.
FIG. 5 is an enlarged plan view of the R1 region of FIG. 4.
FIG. 6 is a plan view illustrating a plurality of channel stack structures, a separation insulating layer, and a plurality of gate structures of a semiconductor device according to examples.
FIGS. 7 to 12 are plan views corresponding to the Q1 region of FIG. 1, illustrating a semiconductor device according to some examples.
FIGS. 13 to 17 are plan views showing a semiconductor device according to some examples.
FIG. 18 is a perspective view showing a semiconductor device according to examples.
FIG. 19A, FIG. 19B, FIGS. 20A to 20E, FIG. 21, FIG. 22, and FIGS. 23A to 23C are drawings of intermediate steps showing a method of manufacturing a semiconductor device according to one example.
FIGS. 24 to 27 are process plan views of intermediate steps illustrating a method of manufacturing a semiconductor device according to the example of FIG. 11.
FIG. 28 is a diagram schematically illustrating an electronic system including a semiconductor device according to some Examples.
FIG. 29 is a perspective view schematically illustrating an electronic system including a semiconductor device according to some examples.
FIGS. 30 and 31 are cross-sectional views schematically illustrating a semiconductor package according to some examples.

### DETAILED DESCRIPTION

Hereinafter, various examples of the present invention will be described in detail with reference to the accompanying drawings so that those skilled in the art to which the present invention pertains may easily carry out the invention. The present invention may be implemented in various different forms and is not limited to the examples described herein.

In order to clearly describe the present invention, portions irrelevant to the description are omitted, and the same reference numerals are assigned to the same or similar components throughout the entire specification.

In addition, the size and thickness of each component shown in the drawings are arbitrarily depicted for convenience of explanation, and therefore, the present invention is not necessarily limited to what is illustrated. In the drawings, the thicknesses have been enlarged to clearly illustrate the various layers and regions. In the drawings, for the convenience of description, the thicknesses of some layers and regions are illustrated in an exaggerated manner for clarity.

In addition, when a portion such as a layer, film, region, or plate is said to be "on" or "over" another portion, this includes not only cases where it is "directly on" the other portion, but also cases where another portion is present between them. Conversely, when a portion is stated to be "directly on" another portion, it means that there is no other portion in between. In addition, stating that it is "on" or "on" a reference portion means that it is positioned above or below the reference portion, and does not necessarily mean being positioned "on" or "on" in a direction opposite to gravity. The terms "upper", "middle", "lower" may refer to relative positions along a particular direction (e.g. a vertical direction). Various directions (e.g. vertical direction, horizontal direction, etc.) may be defined relative to the structure of the devices described herein. It will be appreciated that these directions do not necessarily imply any particular orientation of the device in use.

The term "overlap" (or "overlapping", or like terms), as may be used herein, is intended to broadly refer to a first element that intersects with at least a portion of a second element when viewed in a particular direction (e.g., in a third direction (Z direction), perpendicular to the upper surface of a substrate), but does not require that the first and second elements be completely aligned with one another. Components or layers described with reference to "overlap" in a particular direction may be at least partially obstructed by one another when viewed along a line extending in the particular direction. For instance, components or layers described with reference to "overlap" in a particular direction may be positioned such that a line that runs parallel to the particular direction may be positioned such that it intersects at least a portion of each of the components or layers.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

Also, throughout the specification, when a portion is said to "include" a component, this means that unless specifically stated otherwise, it does not exclude other components but may further include other components.

In addition, throughout the specification, the term "in a plan view" refers to viewing the subject portion from above, and the term "on a cross-sectional view" refers to viewing a cross-section of the subject portion obtained by vertically cutting it, from the side.

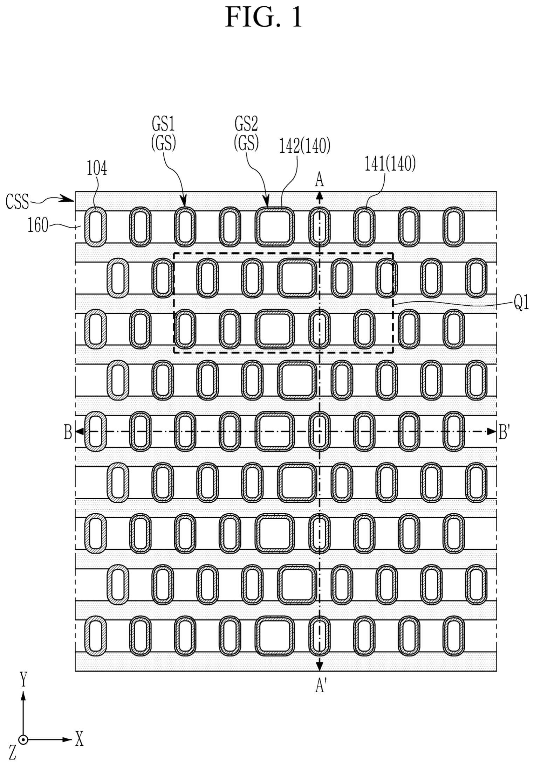

Hereinafter, a semiconductor device according to examples will be described with reference to FIGS. 1 to 3.

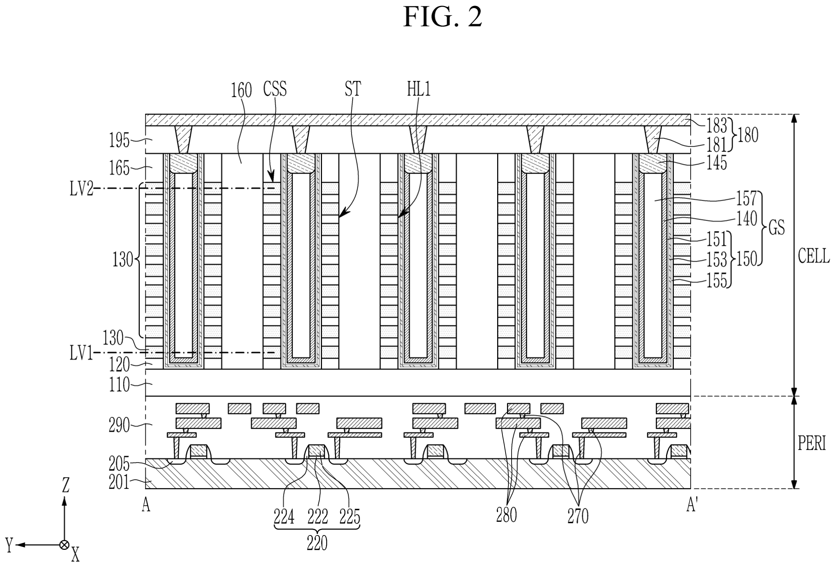

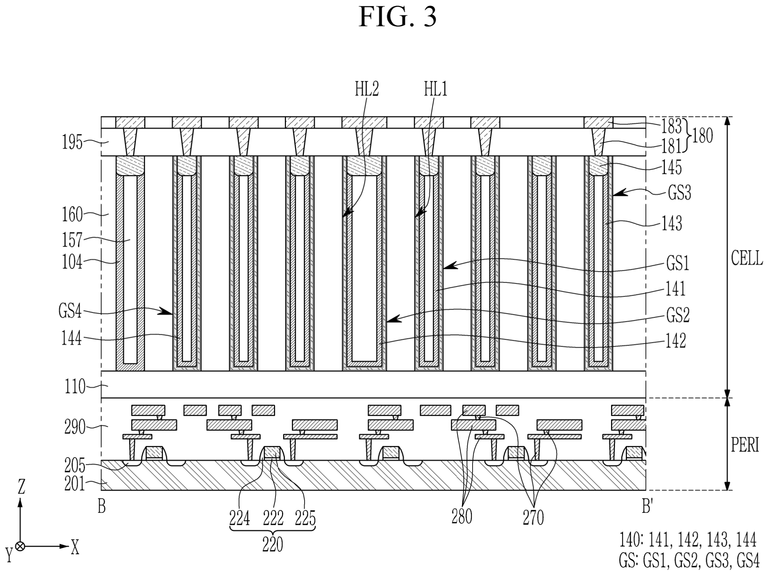

FIG. 1 is a plan view showing a semiconductor device according to examples. FIG. 2 is a cross-sectional view taken along A-A' of FIG. 1. FIG. 3 is a cross-sectional view taken along B-B' of FIG. 1.

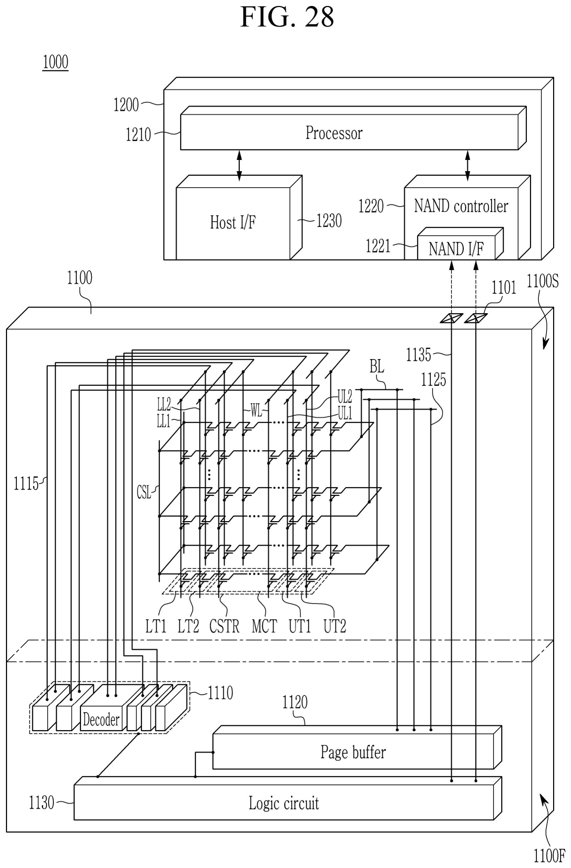

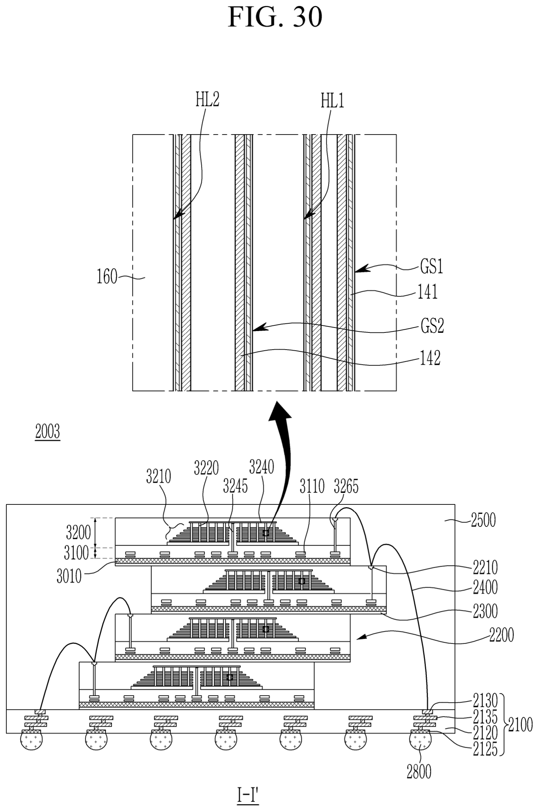

Referring to FIGS. 1 to 3, a semiconductor device according to examples may include a memory cell region CELL and a peripheral circuit region PERI vertically stacked. As examples, the peripheral circuit region PERI and the memory cell region CELL may be portions corresponding to the first structure 1100F and the second structure 1100S of the semiconductor device 1100 included in the electronic system 1000 shown in FIG. 28. Alternatively, the peripheral circuit region PERI and the memory cell region CELL may each be a portion including the first structure 3100 and the second structure 3200 of the semiconductor chip 2200 shown in FIG. 30.

The memory cell region CELL may be positioned on the upper portion of the peripheral circuit region PERI. However, example embodiments are not limited thereto, and in some Examples, the semiconductor device may have the memory cell region CELL and the peripheral circuit region PERI spaced apart and positioned on one substrate. That is, the memory cell region CELL and the peripheral circuit region PERI may not overlap vertically. In some cases, the memory cell region CELL may be positioned below the peripheral circuit region PERI.

The peripheral circuit region PERI may include the main substrate 201, circuit elements 220 positioned on the main substrate 201, circuit contact plugs 270, and circuit wiring lines 280.

The main substrate 201 may have an upper surface extending in a first direction (X direction) and a second direction (Y direction). The second direction (Y direction) may cross (e.g., may be perpendicular to) the first direction (X direction). The main substrate 201 may have separate device isolation layers formed thereon so that an active region may be defined. A portion of the active region may be positioned with source/drain regions 205 including impurities. The main substrate 201 may include a semiconductor material, for example, a group IV semiconductor, a group III-V compound semiconductor, or a group II-VI compound semiconductor. The main substrate 201 may be provided as a bulk wafer or an epitaxial layer, but example embodiments are not limited thereto.

The circuit elements 220 may include a horizontal transistor. Each circuit element 220 may include a circuit gate dielectric layer 222, a spacer layer 224, and a circuit gate electrode 225. Source/drain regions 205 may be positioned on opposite sides of the circuit gate electrode 225.

The peripheral region insulating layer 290 may be positioned on the circuit element 220 on the main substrate 201. The circuit contact plugs 270 may be connected to the source/drain regions 205 through the peripheral region insulating layer 290.

An electrical signal may be applied to the circuit element 220 by the circuit contact plugs 270. In a region not shown, circuit contact plugs 270 may also be connected to the circuit gate electrode 225. The circuit wiring lines 280 may be connected to the circuit contact plugs 270, and may be stacked in multiple layers.

In one Example, the semiconductor device may be manufactured such that the peripheral circuit region PERI is first fabricated, and then the substrate 110 of the memory cell region CELL is formed thereon, so that the memory cell region CELL may be fabricated. The substrate 110 may have the same size as the main substrate 201, or may be formed smaller than the main substrate 201.

The memory cell region CELL may include a substrate 110, a plurality of channel stack structures CSS positioned on the substrate 110 and spaced apart and arranged in the first direction (X direction), and a plurality of gate structures GS positioned between adjacent ones of the plurality of channel stack structures CSS in the first direction (X direction). Here, each of the plurality of channel stack structures CSS may include a plurality of interlayer insulating layers 120 and a plurality of channel layers 130 alternately stacked.

The substrate 110 may have an upper surface extending in the first direction (X direction) and the second direction (Y direction). The substrate 110 may include a semiconductor material, for example, a group IV semiconductor, a group III-V compound semiconductor, or a group II-VI compound semiconductor. For example, the group IV semiconductor may include silicon, germanium, or silicon-germanium. The substrate 110 may be provided as a bulk wafer, an epitaxial layer, an epitaxial layer, a SOI (Silicon On Insulator) layer, or a SeOI (Semiconductor On Insulator) layer. However, this is not limited thereto.

A plurality of channel stack structures CSS may be positioned on the substrate 110. A plurality of channel stack structures CSS may extend in the first direction (X direction). A plurality of channel stack structures CSS may be arranged to be spaced apart in the second direction (Y direction). The plurality of channel stack structures CSS may be separated from each other in the second direction (Y direction) by the separation trench ST. The separation trench ST may extend through the plurality of channel stack structures CSS. For example, a separation insulating layer 160, which will be described later, may be positioned between a plurality of channel stack structures CSS spaced apart and arranged in the second direction (Y direction). A side surface of the plurality of channel stack structures CSS in the second direction (Y direction) may be defined by the separation trench ST.

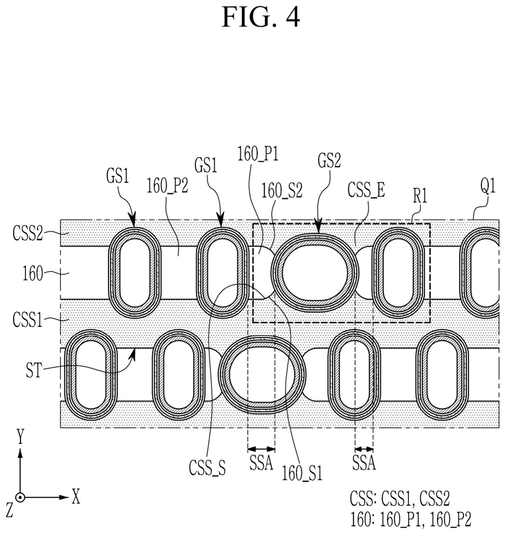

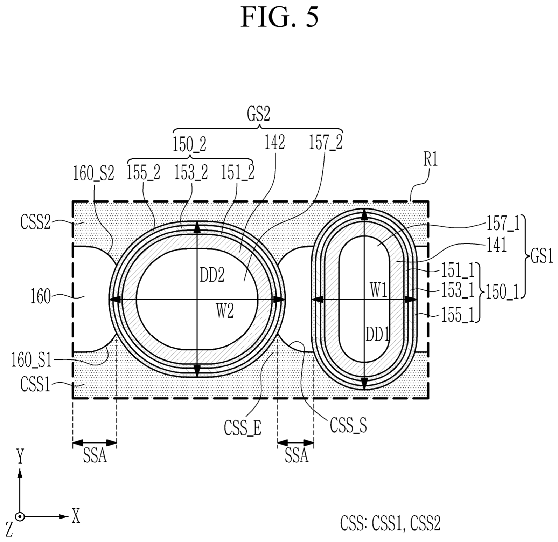

According to examples, the side surface of a plurality of channel stack structures CSS in the second direction (Y direction) may include a curved shape in a plan view. For example, the side surface of the plurality of channel stack structures CSS in the second direction (Y direction) may include a curved shape in a region between the second gate structure (see GS2 in FIG. 4) and the first gate structure (see GS1 in FIG. 4). A detailed description thereof will be provided below with reference to FIG. 4 and FIG. 5. A plan view may be a view in a plane (e.g., a horizontal plane). Here, 'plane' refers to a surface formed in the first direction (X direction) and the second direction (Y direction).

Hereinafter, the expression "in a plan view" may refer to "in a plan view formed in the first direction (X direction) and the second direction (Y direction)."

At least one of the plurality of channel stack structures CSS may be a dummy layer functioning as a device isolation layer, but example embodiments are not limited thereto. For example, as shown in FIG. 1, the channel stack structure CSS positioned at the topmost portion and the channel stack structure CSS positioned at the bottommost portion may be dummy layers for separating from surrounding devices, but example embodiments are not limited thereto. A dummy layer may be a layer that does not perform any active function. For instance, a dummy layer may be a dielectric layer. The dummy layer may comprise one or more layers (e.g., one or more dummy layers).

Each of the plurality of channel stack structures CSS may include a plurality of interlayer insulating layers 120 and a plurality of channel layers 130 alternately stacked.

A plurality of channel layers 130 may be spaced apart in a third direction (Z direction) on the substrate 110 to form each of the plurality of channel stack structures CSS. The plurality of channel layers 130 may each form one memory cell string, and may be spaced apart and arranged in the third direction (Z direction) on the substrate 110. In FIGS. 2 and 3, nine channel layers 130 are illustrated as positioned spaced apart and stacked in the third direction (Z direction), but the number of channel layers 130 is not limited thereto. The third direction (Z direction) may be perpendicular to the first direction (X direction) and the second direction (Y direction).

In addition, the plurality of channel layers 130 may extend in the first direction (X direction) and may be arranged spaced apart in the second direction (Y direction). A plurality of channel layers 130 may be separated from each other in the second direction (Y direction) by a separation trench ST. In FIG. 1, it is illustrated that ten channel layers 130 are spaced apart and arranged in the second direction (Y direction), but the number of channel layers 130 is not limited thereto. At least one of the plurality of channel layers 130 may be serve as a dummy layer functioning as a device isolation layer, but example embodiments are not limited thereto. The plurality of channel layers 130 may include a semiconductor material, for example, polycrystalline silicon. Here, the semiconductor material may be a non-doped material, or a material including either a p-type or n-type impurity.

The plurality of interlayer insulating layers 120 are positioned between the plurality of channel layers 130, and may be alternately positioned with the plurality of channel layers 130 in the third direction (Z direction). That is, the channel layers 130 and the interlayer insulating layers may be alternately stacked in the third direction (Z direction). A plurality of interlayer insulating layers 120, like the plurality of channel layers 130, may be spaced apart from each other in the third direction (Z direction) from an upper surface of the substrate 110. The plurality of interlayer insulating layers 120 may include an insulating material such as silicon oxide or silicon nitride, but example embodiments are not limited thereto.

A semiconductor device according to one example may further include a separation insulating layer 160 positioned between a plurality of channel stack structures CSS.

The separation insulating layer 160 may be positioned between the plurality of channel stack structures CSS adjacent to each other in the second direction (Y direction). The separation insulating layer 160 may extend in the first direction (X direction) and may be arranged spaced apart in the second direction (Y direction). A plurality of channel stack structures CSS may be separated in the second direction (Y direction) by a separation insulating layer 160. For instance, an adjacent pair of channel stack structures CSS may be separated in the second direction (Y direction) by the separation insulating layer 160. The separation insulating layer 160 may be positioned between the plurality of channel layers 130 adjacent in the second direction (Y direction). The plurality of channel layers 130 adjacent in the second direction (Y direction) may be electrically and physically separated from each other by the separation insulating layer 160. The separation insulating layer 160 may be in contact with the plurality of channel stack structures CSS.

As shown in FIG. 1, a plurality of separation insulating layers 160 may be alternately arranged with the plurality of channel structures CSS in the second direction (Y direction). Nevertheless, for simplicity, a single separation insulating layer 160 shall be described below. It will be appreciated that the description of this separation insulating layer 160 may be applied to any of a plurality of separation insulating layers 160.

The separation insulating layer 160 may be positioned in the separation trench ST. For example, the first separation trench ST may extend in the first direction (X direction) and may be arranged spaced apart in the second direction (Y direction). The separation insulating layer 160 may fill the separation trench ST. For example, the separation insulating layer 160 may completely fill the separation trench ST, but example embodiments are not limited thereto. The separation insulating layer 160 may include an insulating material such as silicon oxide or silicon nitride, but example embodiments are not limited thereto.

According to one Example, the separation insulating layer 160 may include a portion having a width that is different in the second direction (Y direction) (e.g., relative to one or more other portions of the separation insulating layer 160). For example, the separation insulating layer 160 may include a portion in which a width in the second direction (Y direction) is reduced. At least a portion of a side surface of the separation insulating layer 160 may have a curved shape in a plan view. For example, a portion of a side surface of the separation insulating layer 160 positioned between the first gate structure (see GS1 in FIG. 4) and the second gate structure (see GS2 in FIG. 4) may have a curved shape. A plan view may be a view in a plane (e.g., a horizontal plane). Here, 'plane' may refer to a plane formed in the first direction (X direction) and the second direction (Y direction). A detailed description thereof will be provided below with further reference to FIG. 4 and FIG. 5.

A plurality of gate structures GS may be positioned between a plurality of channel stack structures CSS. For example, a plurality of gate structures GS may be positioned between a plurality of channel stack structures CSS that are adjacent to each other in the second direction (Y direction). For example, a plurality of gate structures GS may be positioned between a plurality of channel layers 130 adjacent in the second direction (Y direction). The plurality of gate structures GS may be positioned within the separation trench ST. A plurality of gate structures GS may extend in the third direction (Z direction) and may extend through the separation insulating layer 160. The plurality of gate structures GS may be in contact with the plurality of channel stack structures CSS, but example embodiments are not limited thereto. For example, a plurality of gate structures GS may contact the side surfaces of a plurality of channel layers 130, but example embodiments are not limited thereto.

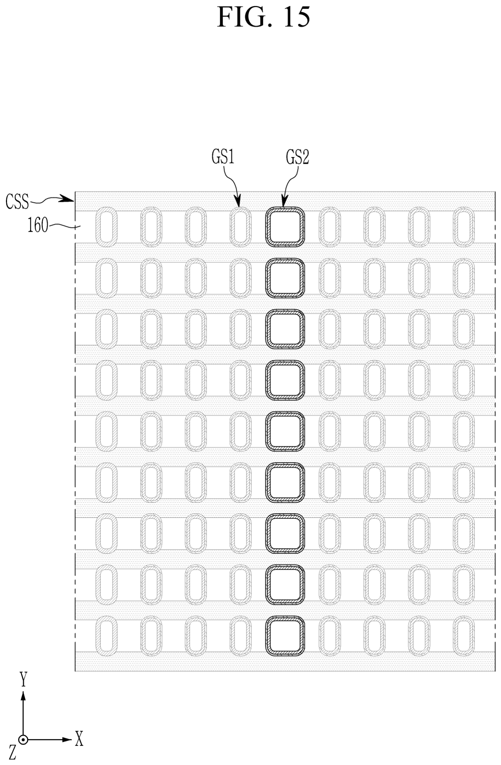

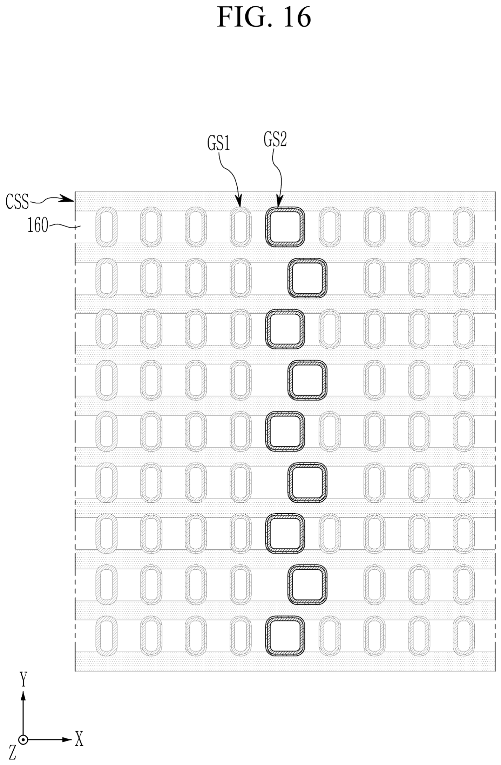

A plurality of gate structures GS may be positioned spaced apart from each other in rows and columns on the substrate 110. For example, the plurality of gate structures GS may be arranged in a zigzag shape in a first diagonal direction intersecting the first direction (X direction) and the second direction (Y direction) on a plane where the first direction (X direction) and the second direction (Y direction) intersect. However, this is not limited thereto, and, the plurality of gate structures GS may be arranged in a lattice pattern in a plan view. Description thereof will be given below with reference to FIG. 15 and FIG. 16.

The plurality of gate structures GS may be provided in holes HL1, HL2 penetrating the separation insulating layer 160. The holes HL1, HL2 may extend in the third direction (Z direction) and penetrate the separation insulating layer 160. The holes HL1, HL2 may be positioned between the plurality of channel stack structures CSS. That is, the plurality of gate structures GS may extend in the third direction (Z direction). Each of the plurality of gate structures GS may have a pillar-shaped structure. A plurality of gate structures GS may have a side surface that is perpendicular to the substrate 110, but example embodiments are not limited thereto. As another example, the plurality of gate structures GS may have an inclined side surface that tapers toward the substrate 110 according to an aspect ratio.

At least one of the plurality of gate structures GS may include a memory gate electrode forming a plurality of memory cells. At least another one of the plurality of gate structures GS may include a ground gate electrode forming a gate of a ground selection transistor. At least one other of the plurality of gate structures GS may include a string selection gate electrode forming a gate of a string selection transistor. For example, as shown in FIG. 3, a semiconductor device according to embodiments may include first to fourth gate structures GS1, GS2, GS3, GS4. The first gate structure GS1 and the second gate structure GS2 may include a first gate electrode 141 and a second gate electrode 142 constituting gates of a plurality of memory cells. The first gate electrode 141 and the second gate electrode 142 may be memory gate electrodes forming a plurality of memory cells. In this case, the number of memory gate electrodes constituting the memory cells may be determined according to the capacity of the semiconductor device. However, this is not limited thereto, and the second gate electrode 142 may be a dummy gate electrode.

The third gate structure GS3 may include a third gate electrode 143 forming the gate of the string selection transistor. The third gate electrode 143 may be the gate electrode of the string selection transistor. The third gate structure GS3 may be one or two or more, but example embodiments are not limited thereto. The third gate structure GS3 may have a structure that is the same as or different from the first gate structure GS1 and the second gate structure GS2. The fourth gate structure GS4 may include the fourth gate electrode 144 forming the gate of the ground selection transistor. The fourth gate electrode 144 may be a ground gate electrode. The fourth gate structure GS4 may be one or two or more, but example embodiments are not limited thereto. The fourth gate structure GS4 may have the same or a different structure as the first gate structure GS1 and the second gate structure GS2.

In some examples, at least some of the plurality of gate structures GS may further include a gate electrode constituting an erase transistor used in an erase operation utilizing a gate induced drain leakage (GIDL) phenomenon. In addition, at least some of the plurality of gate structures GS may be dummy gate structures.

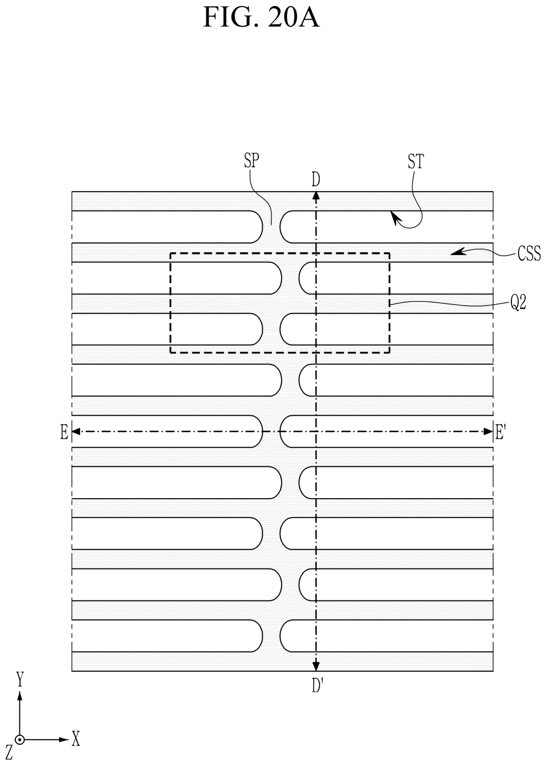

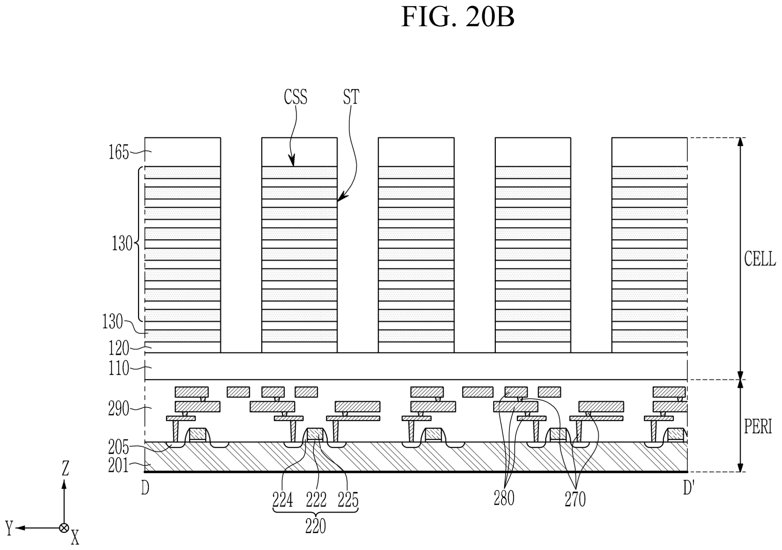

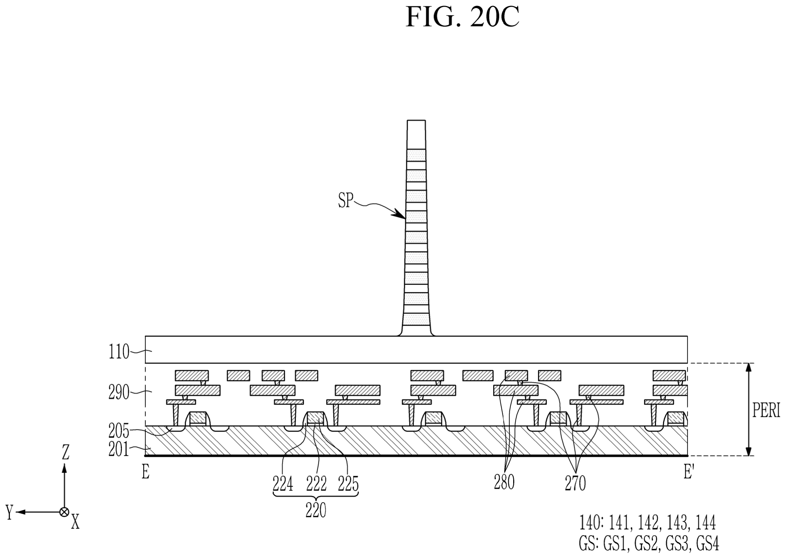

A semiconductor device according to examples may include gate structures GS having different shapes. For example, a semiconductor device according to examples may include a first gate structure GS1 positioned between a plurality of channel stack structures CSS, and a second gate structure GS2 positioned at one side of the first gate structure GS1 in the first direction (X direction). The second gate structure GS2 may include a different shape from the first gate structure GS1. A width of the second gate structure GS2 in the first direction (X direction) may be different from a width of the first gate structure GS1 in the first direction (X direction). A length of the second gate structure GS2 in the second direction (Y direction) may be different from a length of the first gate structure GS1 in the second direction (Y direction). Here, the first gate structure GS1 may be positioned in the first hole HL1 penetrating the separation insulating layer 160. The second gate structure GS2 may be positioned in the second hole HL2 penetrating the separation insulating layer 160. The second hole HL2 may have a different shape from the first hole HL1 in a plan view. This may result from process characteristics in which a support portion (see SP in FIG. 20A) is formed to prevent collapse of the plurality of channel stack structures CSS during the process of forming the plurality of channel stack structures CSS, and subsequently, a second gate structure GS2 is formed in the space from which the support portion (see SP in FIG. 20A) has been removed in a later process. Here, a hole formed to remove the support portion (see SP in FIG. 20A) may be referred to as the second hole HL2, and a hole formed through the separation insulating layer 160 may be referred to as the first hole HL1.

For convenience of explanation, herein, the gate structure GS positioned within the first hole HL1 penetrating the separation insulating layer 160 is referred to as a first gate structure GS1, and the gate structure GS positioned within the second hole HL2, which is formed to remove the support portion (see SP in FIG. 20A), is referred to as a second gate structure GS2. Detailed description of the first gate structure GS1 and the second gate structure GS2 will be provided below with reference to FIG. 4 and FIG. 5.

In one example, the second gate structure GS2 may be positioned at the central portion of the semiconductor device. This is because the support portion (see SP in FIG. 20A) is positioned at the central portion of the semiconductor device to prevent collapse of the plurality of channel stack structures CSS, and the second gate structure GS2 is positioned in the space from which the support portion (see SP in FIG. 20A) has been removed.

Each of a plurality of gate structures GS of a semiconductor device according to examples may include a gate electrode 140 and a gate dielectric layer 150 surrounding the gate electrode 140. The plurality of gate structures GS may further include a core insulating layer 157 positioned inside the gate electrode 140, for example in a central region of the plurality of gate structures GS, but example embodiments are not limited thereto. In another example, the plurality of gate structures GS may not include the core insulating layer 157.

The gate electrode 140 may surround the core insulating layer 157. The gate electrode 140 may have a planar shape such as an annular shape. However, the example is not limited thereto, and for example, the gate electrode 140 may have a pillar-shaped structure (for example, a cylindrical shape or a polygonal pillar shape). The gate electrode 140 may include various conductive materials. For example, the gate electrode 140 may include a metal material such as tungsten (W), copper (Cu), or aluminum (Al), polycrystalline silicon, a metal nitride (for example, titanium nitride (TiN), tantalum nitride (TaN), etc.), or a combination thereof.

The gate dielectric layer 150 may include a blocking layer 151, a charge storage layer 153, and a tunneling layer 155 sequentially positioned on the side surface of the gate electrode 140.

The core insulating layer 157 may include various insulating materials. For example, the core insulating layer 157 may include silicon oxide, silicon nitride, silicon oxynitride, or a combination thereof. The tunneling layer 155 may include an insulating material that permits charge tunneling (e.g., between the charge storage layer and the channel layer(s) 130). For example, the tunneling layer 155 may include silicon oxide, silicon oxynitride, and the like. The charge storage layer 153 may serve as a data storage region, and may include polycrystalline silicon, silicon nitride, and the like. The blocking layer 151 may include an insulating material that prevents undesired inflow of charge into the gate electrode 140. For example, the blocking layer 151 may include silicon oxide, silicon nitride, silicon oxynitride, a high dielectric constant material having a dielectric constant higher than silicon oxide, or a combination thereof. However, the material, stacked structure, and the like of the core insulating layer 157 and the gate dielectric layer 150 may be variously modified, and the example is not limited thereto.

A semiconductor device according to examples may further include a conductive layer 104 penetrating the separation insulating layer 160. The conductive layer 104 may be positioned between the plurality of channel stack structures CSS. The conductive layer 104 may extend in the third direction (Z direction) and penetrate the separation insulating layer 160. The conductive layer 104 may function as at least a portion of a common source line of the semiconductor device. The conductive layer 104 may include a conductive material. In another example, the conductive layer 104 may include a semiconductor material such as polycrystalline silicon. One or more bit lines may be positioned at an opposite end of the stack channel stack structures CSS (e.g., in the first direction (X direction)) to the conductive layer 104. For instance, the stack channel structures CSS may extend from the conductive layer 104 to the one or more bit lines. Each bit line may extend in the third direction to connect to a channel layer 130. For instance, a plurality of bit lines may be provided. One bit line may connect to a corresponding one of the plurality of channel layers 130. Different bit lines may connect to channel layers 130 at different levels (e.g., different relative positions along the third direction (Z direction)). For instance, the plurality of channel layers 130 may form a staircase structure.

A semiconductor device according to one example may further include a gate pad 145 electrically connected to the plurality of gate structures GS. The gate pad 145 may be positioned on an upper portion of the plurality of gate structures GS. The gate pad 145 may be electrically connected to the gate electrode 140 of the plurality of gate structures GS. For each gate structure GS a corresponding gate pad 145 may be electrically connected to the gate electrode 140 of the gate structures GS. For example, the gate pad 145 may be positioned on the upper surface of the gate electrode 140 and the core insulating layer 157, and may be surrounded by the gate dielectric layer 150. However, this is not limited thereto, and the gate pad 145 may be positioned on the gate electrode 140, the core insulating layer 157, and the gate dielectric layer 150. The gate pad 145 may include a conductive material, for example, polycrystalline silicon doped with an impurity, but example embodiments are not limited thereto.

A semiconductor device according to examples may further include a cell region insulating layer 165.

The cell region insulating layer 165 may be positioned on the plurality of channel stack structures CSS. The cell region insulating layer 165 may cover the plurality of channel stack structures CSS including the plurality of channel layers 130 and the plurality of interlayer insulating layers 120. A plurality of gate structures GS may penetrate the cell region insulating layer 165. The cell region insulating layer 165 may include the same material as the plurality of interlayer insulating layers 120, but example embodiments are not limited thereto. In some Examples, the cell region insulating layer 165 may be formed of an interlayer insulating layer 120 at the uppermost portion, but example embodiments are not limited thereto. The cell region insulating layer 165 may include at least one of silicon oxide, silicon nitride, or silicon oxynitride, but example embodiments are not limited thereto.

A semiconductor device according to one example may further include an upper insulating layer 195. The upper insulating layer 195 may be positioned on the cell region insulating layer 165. The upper insulating layer 195 may cover the upper surface of the cell region insulating layer 165. The upper insulating layer 195 may include at least one of silicon oxide, silicon nitride, and silicon oxynitride.

A semiconductor device according to examples may further include an upper wiring structure 180.

The upper wiring structure 180 may be electrically connected to the plurality of gate structures GS. For example, the upper wiring structure 180 may be electrically connected to the gate electrode 140 of the plurality of gate structures GS through the gate pads 145. The upper wiring structure 180 may include a conductive material. The upper wiring structure 180 may include one or more contact plugs 181, and an upper wiring 183. One contact plug may be provided for each of a plurality of gate structures GS that are overlapped by the upper wiring 183 (e.g., in the third direction D3). Each contact plug 181 may penetrate the upper insulating layer 195. The contact plug 181 may be in contact with the upper surface of the corresponding gate pad 145. In FIGS. 2 and 3, a plan area of the contact plug 181 is shown as being smaller than a plan area of the gate pad 145. However, this is for illustrative purposes in describing the contact plug 181, and the plan area of the contact plug 181 may be substantially equal to or greater than the plan area of the gate pad 145.

The upper wiring 183 may be positioned on the contact plug(s) 181 and the upper insulating layer 195. A portion of the upper wiring 183 may be word lines (see WL' of FIG. 28) in contact with the contact plug(s) 181. The word lines may extend in the second direction (Y direction). The word lines may be electrically connected to a plurality of gate structures GS through the contact plugs 181.

Hereinafter, a description will be given of the first gate structure GS1, the second gate structure GS2, and the plurality of channel stack structures CSS of the semiconductor device according to one example, with further reference to FIG. 4 and FIG. 5.

FIG. 4 is an enlarged plan view of the Q1 region of FIG. 1. FIG. 5 is a plan view showing an enlarged R1 region of FIG. 4. In FIG. 4, for convenience of explanation, a plurality of gate structures GS, a plurality of channel stack structures CSS, and a separation insulating layer positioned between the plurality of channel stack structures CSS are illustrated. In this case, the plurality of channel stack structures CSS of the semiconductor device according to embodiments may include a first channel stack structure CSS1 and a second channel stack structure CSS2 positioned apart from the first channel stack structure CSS1 in the second direction (Y direction). The second channel stack structure CSS2 is a channel stack structure adjacent to the first channel stack structure CSS1 in the second direction (Y direction).

With further reference to FIG. 4 and FIG. 5, as described above, a semiconductor device according to embodiments may include a first gate structure GS1 positioned between a plurality of channel stack structures CSS, and a second gate structure GS2 positioned at one side of the first gate structure GS1 in the first direction (X direction). Here, the first gate structure GS1 refers to a gate structure GS positioned in a first hole HL1 penetrating the separation insulating layer 160, and the second gate structure GS2 refers to a gate structure GS positioned in a second hole HL2, after removal of a support portion (see SP in FIG. 20A) formed to prevent collapse of the plurality of channel stack structures CSS is removed. A semiconductor device according to embodiments may comprise a plurality of first gate structures GS1 and a plurality of second gate structures GS2.

The first gate structures GS1 may be arranged in rows and columns on the substrate 110. The first gate structures GS1 may be spaced apart and arranged in the first direction (X direction). The first gate structures GS1 may be spaced apart and arranged in the second direction (Y direction). For example, a plurality of first gate structures GS1 may be arranged in a zigzag pattern in a plan view in a first diagonal direction that intersects the first direction (X direction) and the second direction (Y direction).

The first gate structures GS1 may be positioned between the plurality of channel stack structures CSS. For example, one or more first gate structures GS1 may be positioned between the first channel stack structure CSS1 and the second channel stack structure CSS2. For example, a row of first gate structures GS1 may be positioned between the first channel stack structure CSS1 and the second channel stack structure CSS2. For example, the first gate structure(s) GS1 may be positioned between the plurality of channel layers 130 adjacent in the second direction (Y direction). The first gate structure(s) GS1 may be positioned within the separation trench ST.

Each first gate structure GS1 may extend in the third direction (Z direction) and penetrate the separation insulating layer 160. At least a portion of the first gate structure GS1 may penetrate the plurality of channel stack structures CSS. The first gate structure GS1 may be in contact with the plurality of channel stack structures CSS, but example embodiments are not limited thereto. For example, the first gate structure GS1 may contact the side surface of the plurality of channel layers 130, but example embodiments are not limited thereto.

The first gate structure GS1 may have a rounded quadrilateral shape in a plan view. As another example, the first gate structure GS1 may have a polygonal shape, an elliptical shape, or a circular shape in a plan view. The first gate structure GS1 may have a first width W1 in the first direction (X direction), and a first length DD1 in the second direction (Y direction). The first length DD1 of the first gate structure GS1 in the second direction (Y direction) may be greater than the width of the separation insulating layer 160 in the second direction (Y direction). Accordingly, at least a portion of the first gate structure GS1 may overlap the plurality of channel stack structures CSS in the first direction (X direction).

A second gate structure GS2 may be positioned at one side of the first gate electrode 141 of a first gate structure GS1 in the first direction (X direction). For example, the second gate structure GS2 may be positioned between the first gate structures GS1 adjacent in the first direction (X direction). For example, the second gate structure GS2 may be positioned between two first gate structures GS1 that are adjacent to each other in the first direction (X direction).

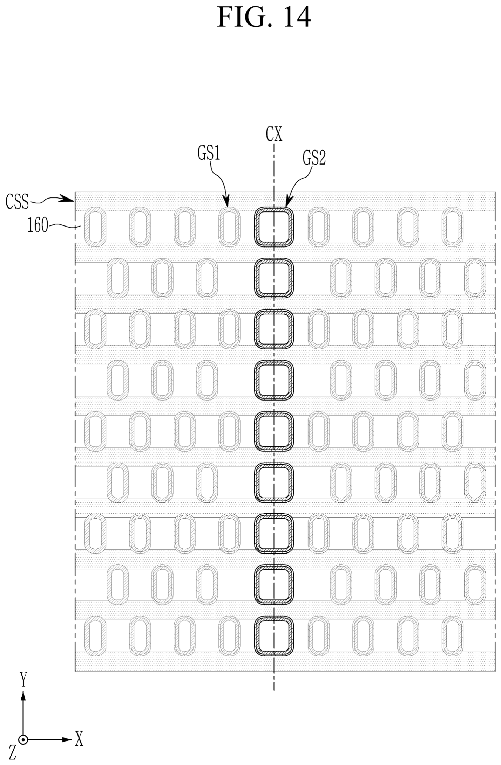

The semiconductor device may comprise a plurality of second gate structures GS2. The second gate structures GS2 may be spaced apart and arranged in the second direction (Y direction). For example, a plurality of second gate structures GS2 may be arranged in a zigzag pattern in a plan view in a first diagonal direction intersecting the first direction (X direction) and the second direction (Y direction). However, this is not limited thereto, and a plurality of second gate structures GS2 may be arranged spaced apart from each other in the second direction (Y direction). A description thereof will be provided below with reference to FIG. 14 and FIG. 15.

The second gate structure GS2 may be positioned between the plurality of channel stack structures CSS. For example, one or more second gate structures GS2 may be positioned between the first channel stack structure CSS1 and the second channel stack structure CSS2. For example, a row of second gate structures GS2 may be positioned between the first channel stack structure CSS1 and the second channel stack structure CSS2. For example, the second gate structure(s) GS2 may be positioned between the plurality of channel layers 130 adjacent in the second direction (Y direction).

Each second gate structure GS2 may extend in the third direction (Z direction) and penetrate the separation insulating layer 160. At least a portion of the second gate structure GS2 may penetrate the plurality of channel stack structures CSS. The second gate structure GS2 may be in contact with the plurality of channel stack structures CSS, but example embodiments are not limited thereto. For example, the second gate structure GS2 may be in contact with the side surfaces of the plurality of channel layers 130, but example embodiments are not limited thereto.

The second gate structure GS2 may have a rounded quadrilateral shape in a plan view. As another example, the second gate structure GS2 may have a polygonal shape, an elliptical shape, a circular shape, or the like in a plan view. The planar shape of the second gate structure GS2 may be different from the planar shape of the first gate structure GS1. For example, the second gate structure GS2 and the first gate structure GS1 may have a rounded quadrilateral shape. In this case, an area of the second gate structure GS2 may be different from an area of the first gate structure GS1 in a plan view. For example, the area of the second gate structure GS2 may be greater than the area of the first gate structure GS1 in a plan view. However, this is not limited thereto, and the area of the second gate structure GS2 may be substantially equal to the area of the first gate structure GS1 in a plan view. In another example, the second gate structure GS2 may have a rounded quadrilateral shape, and the first gate structure GS1 may have an elliptical shape. The planar shapes of the first gate structure GS1 and the second gate structure GS2 may be variously changed.

The second gate structure GS2 may have a second width W2 in the first direction (X direction). The second width W2 of the second gate structure GS2 in the first direction (X direction) may be greater than the first width W1 of the first gate structure GS1 in the first direction (X direction). For example, the second width W2 of the second gate structure GS2 in the first direction (X direction) may be from 1.2 to 2 times the first width W1 of the first gate structure GS1 in the first direction (X direction), but example embodiments are not limited thereto. This may result from process characteristics of forming a support portion (see SP in FIG. 20A) to prevent collapse of the plurality of channel stack structures CSS during the formation of the plurality of channel stack structures CSS, and then forming a second gate structure GS2 in the space from which the support portion (see SP in FIG. 20A) has been removed in a subsequent process. In this case, the second gate structure GS2 may be formed with a sufficient width to remove at least a portion of the support portion (see SP in FIG. 20A) so that the first channel stack structure CSS1 and the second channel stack structure CSS2 are separated in the second direction (Y direction).

In addition, the second gate structure GS2 may have a second length DD2 in the second direction (Y direction). The second length DD2 of the second gate structure GS2 in the second direction (Y direction) may be different from the first length DD1 of the first gate structure GS1 in the second direction (Y direction). For example, as shown in FIG. 4 and FIG. 5, the second length DD2 of the second gate structure GS2 in the second direction (Y direction) may be smaller than the first length DD1 of the first gate structure GS1 in the second direction (Y direction). The second length DD2 of the second gate structure GS2 in the second direction (Y direction) may be greater than the width of the separation insulating layer 160 in the second direction (Y direction), but example embodiments are not limited thereto. Accordingly, at least a portion of the second gate structure GS2 may overlap with the plurality of channel stack structures CSS in the first direction (X direction).

The contact area between the second gate structure GS2 and the plurality of channel stack structures CSS may be greater than the contact area between the first gate structure GS1 and the plurality of channel stack structures CSS. For example, the contact area between the second gate structure GS2 and the first channel stack structure CSS1 may be greater than the contact area between the first gate structure GS1 and the first channel stack structure CSS1. The contact area between the second gate structure GS2 and the plurality of channel layers 130 of the first channel stack structure CSS1 may be greater than the contact area between the first gate structure GS1 and the plurality of channel layers 130 of the first channel stack structure CSS1.

The first gate structure GS1 of the semiconductor device according to examples may include a first core insulating layer 157_1, a first gate electrode 141 surrounding the first core insulating layer 157_1, and a first gate dielectric layer 150_1 surrounding the first gate electrode 141. The first gate dielectric layer 150_1 may include a first blocking layer 151_1 surrounding the first gate electrode 141, a first charge storage layer 153_1 surrounding the first blocking layer 151_1, and a first tunneling layer 155_1 surrounding the first charge storage layer 153_1. The first gate electrode 141 may be a memory gate electrode including a plurality of memory cells.

The first charge storage layer 153_1 may surround the first gate electrode 141. The first blocking layer 151_1 may be positioned between the first gate electrode 141 and the first charge storage layer 153_1. The first tunneling layer 155_1 may be positioned between the first charge storage layer 153_1 and the plurality of channel layers 130, and between the first charge storage layer 153_1 and the plurality of interlayer insulating layers 120. The first blocking layer 151_1, the first charge storage layer 153_1, and the first tunneling layer 155_1 may have an annular shape in a plan view, but example embodiments are not limited thereto.

In one Example, the second gate structure GS2 of the semiconductor device may include a second core insulating layer 157_2, a second gate electrode 142 surrounding the second core insulating layer 157_2, and a second gate dielectric layer 150_2 surrounding the second gate electrode 142. The second gate dielectric layer 150_2 may include a second blocking layer 151_2 surrounding the second gate electrode 142, a second charge storage layer 153_2 surrounding the second blocking layer 151_2, and a second tunneling layer 155_2 surrounding the second charge storage layer 153_2.

The second blocking layer 151_2 may be positioned between the second gate electrode 142 and the second charge storage layer 153_2. The second blocking layer 151_2 may have an annular shape, but example embodiments are not limited thereto. The thickness of the second blocking layer 151_2 may be substantially equal to the thickness of the first blocking layer 151_1. This may be due to a process characteristic of simultaneously forming the second blocking layer 151_2 and the first blocking layer 151_1.

The second charge storage layer 153_2 may surround the second gate electrode 142. The second charge storage layer 153_2 may have an annular shape, but example embodiments are not limited thereto. The thickness of the second charge storage layer 153_2 may be substantially equal to the thickness of the first charge storage layer 153_1. This may be due to process characteristics of simultaneously forming the second charge storage layer 153_2 and the first charge storage layer 153_1.

The second tunneling layer 155_2 may be positioned between the second charge storage layer 153_2 and the plurality of channel layers 130, and also between the second charge storage layer 153_2 and the plurality of interlayer insulating layers 120. The second tunneling layer 155_2 may have an annular shape, but example embodiments are not limited thereto. The thickness of the second tunneling layer 155_2 may be substantially equal to the thickness of the first tunneling layer 155_1. This may be due to a process characteristic of forming the second tunneling layer 155_2 and the first tunneling layer 155_1 simultaneously.

The thickness of the second gate electrode 142 may be substantially equal to the thickness of the first gate electrode 141. This may result from process characteristics of simultaneously forming the second gate electrode 142 and the first gate electrode 141. A width of the second core insulating layer 157_2 in the first direction (X direction) may be greater than or equal to a width of the first core insulating layer 157_1 in the first direction (X direction). This may be due to a process characteristic in which, during the process of removing the support portion (see SP in FIG. 20A) to form the second hole HL2, a width of the second hole HL2 in the second direction (Y direction) is greater than or equal to a width of the first hole HL1 in the first direction (X direction).

According to one example, the second gate electrode 142 may be a memory gate electrode constituting a plurality of memory cells. In this case, a second memory gate voltage for driving the memory cell may be applied to the second gate electrode 142, and a first memory gate voltage for driving the memory cell may be applied to the first gate electrode 141. Since the contact area between the second gate structure GS2 and the plurality of channel stack structures CSS is greater than the contact area between the first gate structure GS1 and the plurality of channel stack structures CSS, in order for the memory cell to operate uniformly by the first gate structure GS1 and the second gate structure GS2, the second memory gate voltage may be smaller than the first memory gate voltage. However, example embodiments are not limited thereto, and the second memory gate voltage may be substantially equal to or greater than the first memory gate voltage.

In another example, the second gate electrode 142 may be a dummy gate electrode. When the second gate electrode 142 is a dummy gate electrode, a dummy voltage for driving the memory cell may be applied to the second gate electrode 142. The dummy voltage may be different from the first memory gate voltage applied to the first gate electrode 141. For example, the dummy voltage may be smaller than the first memory gate voltage; however, it is not limited thereto.

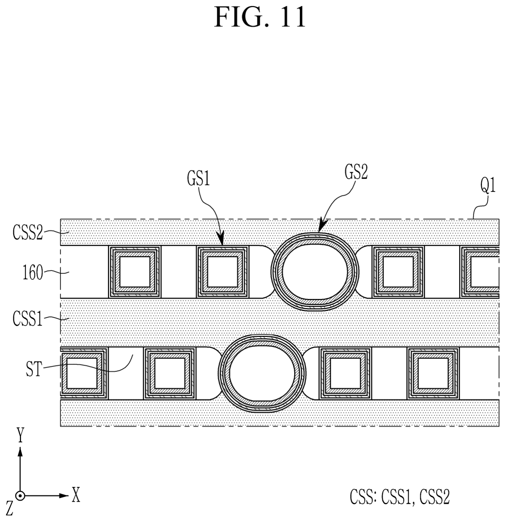

In FIGS. 4 and 5, the thickness of the second gate dielectric layer 150_2 is shown to be substantially equal to the thickness of the first gate dielectric layer 150_1, and the thickness of the second gate electrode 142 is shown to be substantially equal to the thickness of the first gate electrode 141, but example embodiments are not limited thereto. In another example, the thickness of the second gate dielectric layer 150_2 may be greater than the thickness of the first gate dielectric layer 150_1. This may result from process characteristics of forming the second gate dielectric layer 150_2 and the first gate dielectric layer 150_1 in different processes. A detailed description thereof will be provided below with reference to FIG. 11.

In one example, the separation insulating layer 160 of the semiconductor device may include a first portion 160_P1 positioned between the first gate structure GS1 and the second gate structure GS2. The first portion 160_P1 may be positioned on opposite sides of the second gate structure GS2 in the first direction (X direction).

The first portion 160_P1 may include a portion having a width that decreases in the second direction (Y direction). That is, a width of the first portion 160_P1 in the second direction (Y direction) may include a portion that decreases as a distance from the first gate structure GS1 increases. That is, a width of the first portion 160_P1 in the second direction (Y direction) may decrease as a distance from the first gate structure GS1 increases. For example, a width in the second direction (Y direction) of the first portion 160_P1 adjacent to the first gate structure GS1 may be greater than a width in the second direction (Y direction) of the first portion 160_P1 adjacent to the second gate structure GS2.

The first portion 160_P1 may include side surfaces 160_S1, 160_S2 in contact with the plurality of channel stack structures CSS in a plan view. For example, the first portion 160_P1 may include a first side surface 160_S1 in contact with the first channel stack structure CSS1 and a second side surface 160_S2 in contact with the second channel stack structure CSS2 in a plan view. A first side surface 160_S1 and a second side surface 160_S2 of a first portion 160_P1 may include a curved surface in a plan view. For example, the first side surface 160_S1 of the first portion 160_P1 may include a convex curved surface toward the first channel stack structure CSS1 in a plan view. The second side surface 160_S2 of the first portion 160_P1 may include a convex curved surface toward the second channel stack structure CSS2 in a plan view. This may be due to a process characteristic in which a separation trench ST is formed so that a support portion (see SP in FIG. 20A) is formed between a plurality of channel stack structures CSS adjacent in the second direction (Y direction) to prevent the collapse of the plurality of channel stack structures CSS.

In one example, the separation insulating layer 160 of the semiconductor device may further include a second portion 160_P2 positioned between the first gate structures GS1 adjacent in the first direction (X direction). For instance, a second portion 160_P2 positioned between two first gate structures GS1 adjacent to each other in the first direction (X direction). The side surface of the second portion 160_P2 may not include a curved surface in a plan view. For example, a side surface of the second portion 160_P2 in contact with the first channel stack structure CSS1 and a side surface of the second portion 160_P2 in contact with the second channel stack structure CSS2 may be a planar surface extending in the first direction (X direction). For example, each of a side surface of the second portion 160_P2 in contact with the first channel stack structure CSS1 and a side surface of the second portion 160_P2 in contact with the second channel stack structure CSS2 may be a straight surface extending in the first direction (X direction). A width of the second portion 160_P2 in the second direction (Y direction) may be constant. A width of the second portion 160_P2 in the second direction (Y direction) may be greater than a width in the second direction (Y direction) of the first portion 160_P1 at a point adjacent to the second gate structure GS2. A width of the second portion 160_P2 in the second direction (Y direction) may be greater than or equal to (e.g., may be the same as) a width of the first portion 160_P1 in the second direction (Y direction) at a point adjacent to the first gate structure GS1.

Accordingly, the side surface of the plurality of channel stack structures CSS of the semiconductor device according to examples may include a curved shape. For example, a side surface CSS_S of the first channel stack structure CSS1 contacting the first portion 160_P1 may include a concave curved shape. That is, in the support region SSA between the second gate structure GS2 and the first gate structure GS1, the side surface CSS_S of the first channel stack structure CSS1 may include a concave curved shape. Accordingly, in a region adjacent to the second gate structure GS2, a second distance DS2 between the second channel stack structure CSS2 and the first channel stack structure CSS1 in the second direction (Y direction) may be smaller than a first distance DS1 in the second direction (Y direction) between the second channel stack structure CSS2 and the first channel stack structure CSS1 in a region adjacent to the first gate structure GS1. This is because the side surface of the plurality of channel stack structures CSS defined by the separation trench ST has a complementary shape to the side surface of the separation insulating layer 160 filling the separation trench ST.

A plurality of channel stack structures CSS of a semiconductor device according to one example may include a protrusion portion CSS_E recessed into a space between a first portion 160_P1 and a second gate structure GS2.

The protrusion portion CSS_E is positioned within a space between the first portion 160_P1 and the second gate structure GS2, and refers to a portion of the plurality of channel stack structures CSS having a side surface with a curved shape in a plan view. The protrusion portion CSS_E may be at least a portion of the support portion (see SP in FIG. 20A) remaining after removal by the second hole HL2. The protrusion portion CSS_E may be spaced apart from the first gate structure GS1 and may contact the second gate structure GS2. The protrusion portion CSS_E may be positioned adjacent to the second gate structure GS2. The protrusion portion CSS_E may be positioned on at least one side of the second gate structure GS2 in accordance with the second direction (Y direction). For example, protrusion portions CSS_E may be positioned at opposite sides of the second gate structure GS2 in the second direction (Y direction), but example embodiments are not limited thereto.

A semiconductor device according to examples may, in a process of forming a plurality of channel stack structures CSS, form a support portion (see SP in FIG. 20A) between the plurality of channel stack structures CSS adjacent in the second direction (Y direction). A second gate structure GS2 may be formed by removing at least a portion of the support portion (see SP in FIG. 20A) in a subsequent process, and a first gate structure GS1 may be formed penetrating the separation insulating layer 160. In this case, the second gate structure GS2 may be formed to have a sufficient width to separate the plurality of channel stack structures CSS adjacent to each other in the second direction (Y direction) from each other in the process of removing at least a portion of the support portion (see SP in FIG. 20A).

In addition, a semiconductor device according to one example may include a process of forming a support portion (see SP in FIG. 20A) between a plurality of channel stack structures CSS adjacent in the second direction (Y direction), and a process of removing at least a portion of the support portion (see SP in FIG. 20A) in a subsequent process. Accordingly, a side surface of the separation insulating layer 160 may include a curved surface, and a side surface of the plurality of channel stack structures CSS in the support region SSA may include a curved surface. That is, the plurality of channel stack structures CSS may include a protrusion portion CSS_E recessed into a space between the first portion 160_P1 and the second gate structure GS2. Accordingly, in the process of manufacturing a semiconductor device, it may be possible to prevent a plurality of channel stack structures CSS from collapsing, and defects in the semiconductor device may be prevented.

In the embodiment, the second gate structure GS2 may have a shape different from that of the first gate structure GS1, the plurality of channel stack structures CSS may include the protrusion portion CSS_E, and side surfaces of the separation insulating layer 160 may include curved surfaces. For example, the second width W2 of the second gate structure GS2 in the first direction (X direction) may be greater than the first width W1 of the first gate structure GS1 in the first direction (X direction). The second length DD2 of the second gate structure GS2 in the second direction (Y direction) may be different from the first length DD1 of the first gate structure GS1 in the second direction (Y direction). Also, the contact area between the second gate structure GS2 and the plurality of channel stack structures CSS may be greater than the contact area between the first gate structure GS1 and the plurality of channel stack structures CSS. Due to these structural features, the lateral stiffness of the plurality of channel stack structures CSS, which extend in the first direction (X direction) and have a relatively narrow width in the second direction (Y direction), may be increased. Accordingly, the plurality of channel stack structures CSS may be prevented from tilting or collapsing in the second direction (Y direction), thereby preventing defects in the semiconductor device.

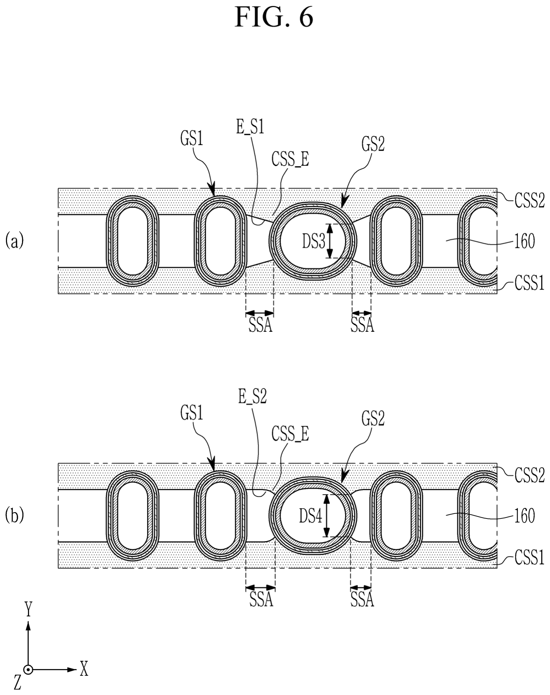

Hereinafter, a further description will be given of the protrusion portion CSS_E of the plurality of channel stack structures CSS according to one example with further reference to FIG. 6.

FIG. 6 is a plan view showing a plurality of channel stack structures, a separation insulating layer, and a plurality of gate structures of a semiconductor device according to examples. FIG. 6(a) is a cross-sectional view showing the plurality of channel layers 130, the separation insulating layer 160, the first gate electrode 141, and the second gate electrode 142 corresponding to a first level LV1 in FIG. 2. FIG. 6(b) is a cross-sectional view showing a plurality of channel layers 130, a separation insulating layer 160, a first gate electrode 141, and a second gate electrode 142 corresponding to a second level LV2 in FIG. 2. The cross-sectional views of FIGS. 6(a) and 6(b) may be taken in planes that run parallel to the first direction (X direction) and the second direction (Y direction) at first and second levels LV1 and LV2, respectively. The first and second levels LV1 and LV2 may be respective positions along the third direction (Z direction). The second level LV2 may be higher than the first level LV1. In the present context, a higher level (e.g., relative to a lower level) may be a level that is further along the third direction D3 (e.g., further from the substrate 110) (e.g., than the lower level). The first level LV1 may correspond to the level of the central portion of a plurality of channel layers 130 positioned at the lowermost portion of the plurality of channel stack structures CSS. The second level LV2 may correspond to the level of a central portion of a plurality of channel layers 130 positioned at an uppermost portion of a plurality of channel stack structures CSS.

Referring further to FIG. 6, the side surface of the protrusion portion CSS_E may include surfaces (e.g., curved surfaces) having different curvatures at different levels. For example, the side surface E_S1 of the protrusion portion CSS_E at the first level LV1 may include a surface (e.g., a straight or curved surface) having a first curvature. Where the surface is straight, the curvature may be zero. The side surface E_S2 of the protrusion portion CSS_E at the second level LV2 may include a curved surface having a second curvature. Here, the first curvature may be smaller than the second curvature. In the process of forming the support portion (see SP in FIG. 20A), the support portion (see SP in FIG. 20A) may have an inclined side surface narrowing toward the substrate 110 depending on the aspect ratio, and this may be due to a process characteristic in which the curvature of the support portion (see SP in FIG. 20A) positioned at the lower portion is smaller than the curvature of the support portion (see SP in FIG. 20A) positioned at the upper portion.

A third distance DS3 in the second direction (Y direction) between the first channel stack structure CSS1 and the second channel stack structure CSS2 positioned at the support region SSA at the first level LV1 may be less than a fourth distance DS4 in the second direction (Y direction) between the first channel stack structure CSS1 and the second channel stack structure CSS2 positioned at the support region SSA at the second level LV2. The width in the second direction (Y direction) of the separation insulating layer 160 positioned in the support region SSA at the first level LV1 may be smaller than the width in the second direction (Y direction) of the separation insulating layer 160 positioned in the support region SSA at the second level LV2.

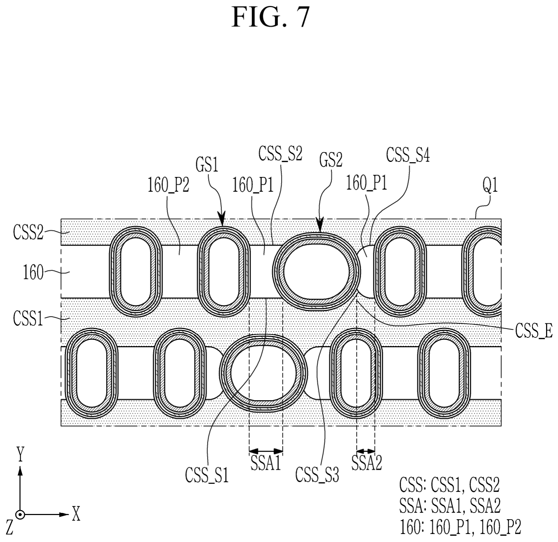

Hereinafter, descriptions will be given of the semiconductor device according to some examples with reference to FIGS. 7 to 12.

FIGS. 7 to 12 are plan views corresponding to the Q1 region of FIG. 1, illustrating semiconductor devices according to some examples.

The embodiments shown in FIGS. 7 to 12 substantially correspond to the same portions as the embodiments shown in FIGS. 1 to 6, and therefore, detailed descriptions thereof will be omitted and the differences will be mainly described.

Referring to FIGS. 7 to 9, in the support region SSA, at least a portion of the plurality of channel stack structures CSS may include a side surface extending in the first direction (X direction). That is, at least one of the side surfaces CSS_S1, CSS_S2, CSS_S3, CSS_S4 of the plurality of channel stack structures CSS adjacent to one second gate structure GS2 may include a side surface extending in the first direction (X direction). For example, at least one of the group consisting of the first side surface CSS_S1 of the first channel stack structure CSS1 in the first support region SSA1 contacting the separation insulating layer 160, the second side surface CSS_S2 of the second channel stack structure CSS2 in the first support region SSA1 contacting the separation insulating layer 160, the third side surface CSS_S3 of the first channel stack structure CSS1 in the second support region SSA2 contacting the separation insulating layer 160, and the fourth side surface CSS_S4 of the second channel stack structure CSS2 in the second support region SSA2 contacting the separation insulating layer 160 may extend in the first direction (X direction). Here, the first support region SSA1 refers to a support region SSA positioned at one side of the second gate structure GS2 in the first direction (X direction), and the second support region SSA2 refers to a support region SSA positioned at the other side of the second gate structure GS2 in the first direction (X direction).

For example, as shown in FIG. 7, in the first support region SSA1, the first side surface CSS_S1 of the first channel stack structure CSS1 and the second side surface CSS_S2 of the second channel stack structure CSS2 may be a planar surface extending in the first direction (X direction). The first side surface CSS_S1 of the first channel stack structure CSS1 and the second side surface CSS_S2 of the second channel stack structure CSS2 may extend in parallel to each other. Accordingly, the distance between the first side surface CSS_S1 of the first channel stack structure CSS1 and the second side surface CSS_S2 of the second channel stack structure CSS2 in the second direction (Y direction) may be constant. In this case, the plurality of channel stack structures CSS may not include a protrusion portion CSS_E at the first support region SSA1.

Accordingly, at least one side surface of a plurality of first portions 160_P1 positioned at opposite sides of the second gate structure GS2 in the first direction (X direction) may extend in the first direction (X direction). For example, the side surface of the first portion 160_P1 positioned on at least one side in the first direction (X direction) of the second gate structure GS2 may not include a curved surface. The width of the first portion 160_P1 in the second direction (Y direction) may be constant.

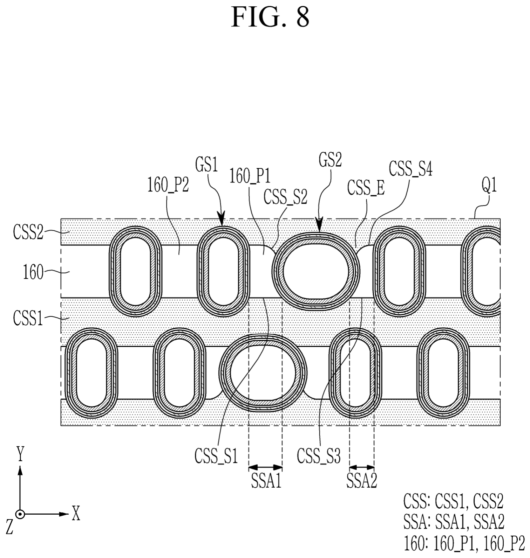

As another example, as shown in FIG. 8, in the first support region SSA1, the first side surface CSS_S1 of the first channel stack structure CSS1 may be a planar surface extending in the first direction (X direction). In the first support region SSA1, the second side surface CSS_S2 of the second channel stack structure CSS2 may include a concave curved surface toward the separation insulating layer 160. In this case, a distance between the first side surface CSS_S1 of the first channel stack structure CSS1 and the second side surface CSS_S2 of the second channel stack structure CSS2 in the second direction (Y direction) may decrease as a distance closer to the second gate structure GS2 increases. In addition, in the second support region SSA2, the third side surface CSS_S3 of the first channel stack structure CSS1 may be a planar surface extending in the first direction (X direction). The fourth side surface CSS_S2 of the second channel stack structure CSS2 in the second direction (Y direction) may include a concave curved surface toward the separation insulating layer 160.

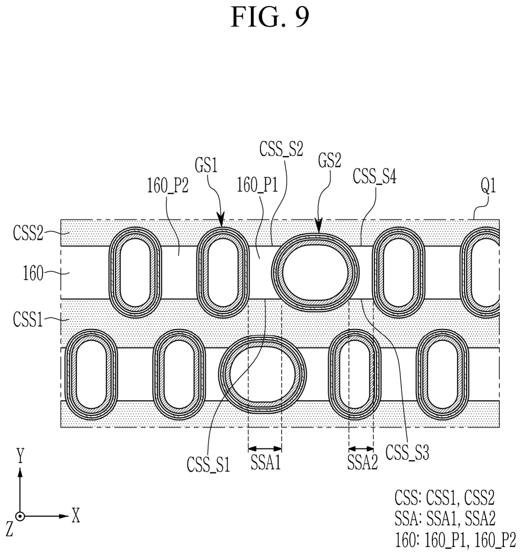

As another example, as shown in FIG. 9, each of the first side surface CSS_S1 of the first channel stack structure CSS1, the third side surface CSS_S3 of the first channel stack structure CSS1, the second side surface CSS_S2 of the second channel stack structure CSS2, and the fourth side surface CSS_S4 of the second channel stack structure CSS2 may be a planar surface extending in the first direction (X direction). The third side surface CSS_S3 of the first channel stack structure CSS1 and the fourth side surface CSS_S4 of the second channel stack structure CSS2 may extend parallel to each other. Accordingly, a distance between the third side surface CSS_S3 of the first channel stack structure CSS1 and the fourth side surface CSS_S4 of the second channel stack structure CSS2 in the second direction (Y direction) may be constant. In this case, the plurality of channel stack structures CSS may not include the protrusion portion CSS_E.

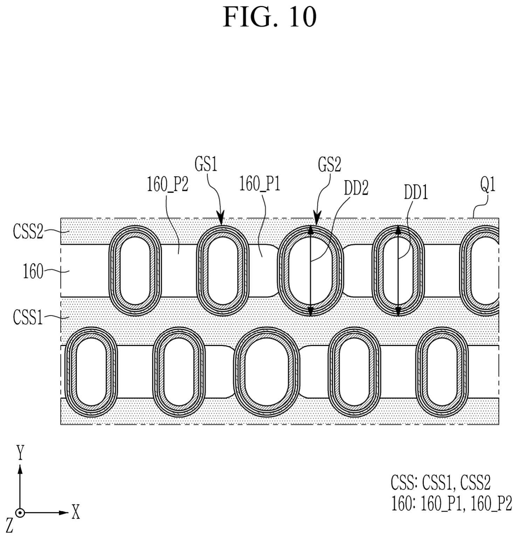

Referring to FIG. 10, the second length DD2 of the second gate structure GS2 of the semiconductor device according to some Examples in the second direction (Y direction) may be substantially equal to the first length DD1 of the first gate structure GS1 in the second direction (Y direction). Opposite end portions of the second gate structure GS2 in the second direction (Y direction) may be aligned with opposite end portions of the first gate structure GS1 in the second direction (Y direction).

Referring to FIG. 11, the second gate structure GS2 of the semiconductor device according to some Examples may have a different shape from the first gate structure GS1.

The first gate structure GS1 may have a rectangular shape in a plan view. The first gate structure GS1 may be positioned in the first hole HL1 penetrating the separation insulating layer 160. The first hole HL1 may penetrate the separation insulating layer 160, and may not recess the plurality of channel stack structures CSS. The first gate structure GS1 may be non-overlapping with the plurality of channel stack structures CSS in the first direction (X direction). The length of the first gate structure GS1 in the second direction (Y direction) may be substantially equal to the width of the separation insulating layer 160 in the second direction (Y direction). This may be due to process characteristics of patterning the separation insulating layer 160 positioned in the separation trench ST to form the first hole HL1.

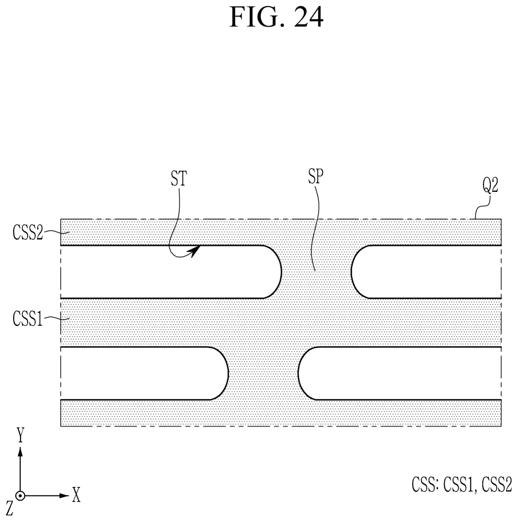

Accordingly, the first gate structure GS1 may have a quadrilateral shape (e.g., with sharp (e.g., right-angled) corners), and the second gate structure GS2 may have a rounded quadrilateral shape (e.g., with rounded corners). An area of the first gate structure GS1 may be smaller than an area of the second gate structure GS2 in a plan view. The length of the second gate structure GS2 in the second direction (Y direction) may be greater than the length of the first gate structure GS1 in the second direction (Y direction). This may result from process characteristics of respectively forming the second hole HL2 in which the second gate structure GS2 is positioned and the first hole HL1 in different processes. A detailed description thereof will be provided below with reference to FIGS. 24 to 27.

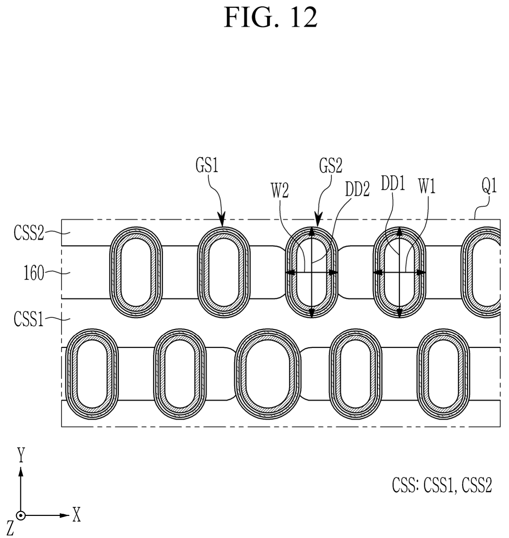

Referring to FIG. 12, the second gate structure GS2 of the semiconductor device according to some Examples may have substantially the same shape as the first gate structure GS1. The second width W2 of the second gate structure GS2 in the first direction (X direction) may be substantially equal to the first width W1 of the first gate structure GS1 in the first direction (X direction). The second length DD2 of the second gate structure GS2 in the second direction (Y direction) may be substantially equal to the first length DD1 of the first gate structure GS1 in the first direction (X direction). In the case of the example of FIG. 12, the side surface of the separation insulating layer 160 adjacent to the second gate structure GS2 may include a curved surface. Also, in the region, the plurality of channel stack structures CSS may include a protrusion portion CSS_E intruding into a space between the second gate electrode 142 and the separation insulating layer 160.

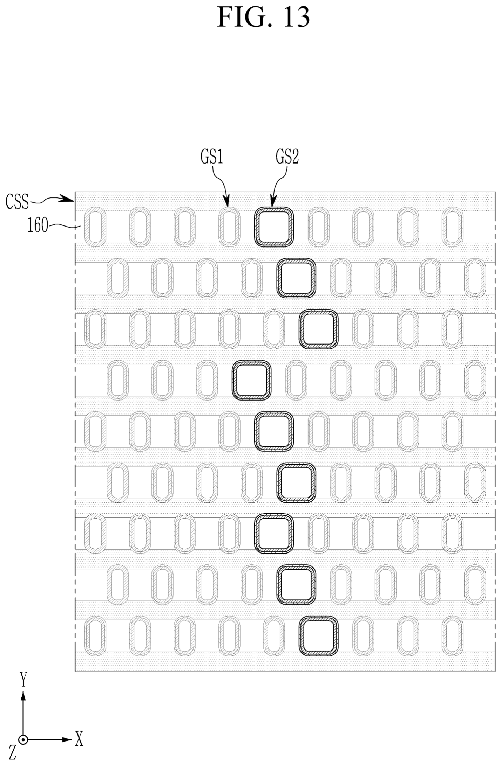

Referring to FIG. 13, the second gate structure GS2 of the semiconductor device according to some Examples may be arranged in a zigzag pattern in the first diagonal direction DR1 intersecting with the first direction (X direction) and the second direction (Y direction). For example, the second gate structure GS2 may be repeatedly arranged in three units in the second direction (Y direction), and the three second gate structures GS2 as one repetition unit may be arranged spaced apart from each other in the first diagonal direction DR1. However, example embodiments are not limited thereto, and the number of the second gate structures GS2 that are spaced apart and arranged in the first diagonal direction DR1 is not limited thereto.

Referring to FIG. 14, the second gate structure GS2 may be arranged spaced apart from each other in the second direction (Y direction). For example, the second gate structure GS2 may be arranged along a central axis CX extending in the second direction (Y direction). Here, the central axis CX may be a reference axis extending in the second direction (Y direction) from the central portion of the semiconductor device. In the example of FIG. 14, the first gate structure GS1 may be arranged in a zigzag pattern in the first diagonal direction DR1 intersecting the first direction (X direction) and the second direction (Y direction).

Referring to FIG. 15 and FIG. 16, the first gate structure GS1 of the semiconductor device according to some Examples may be arranged spaced apart from each other in the first direction (X direction) and the second direction (Y direction). The first gate structure GS1 may be arranged in a lattice form spaced apart in the first direction (X direction) and the second direction (Y direction). As shown in FIG. 15, the second gate structure GS2 may be aligned with the first gate structure GS1 in the first direction (X direction) and the second direction (Y direction). The second gate structures GS2 may be arranged spaced apart from each other in the second direction (Y direction). However, this is not limited thereto, and as another example, as shown in FIG. 16, the second gate structure GS2 may be arranged in the first diagonal direction DR1 intersecting the first direction (X direction) and the second direction (Y direction).

Even in the case of the examples of FIGS. 13 to 16, the second gate structure GS2 may be positioned at the central portion of the semiconductor device. For instance, each second gate structure GS2 may be arranged in the first direction (X direction) between two sets of one or more first gate structures GS1. This is because the support portion (see SP in FIG. 20A) is positioned at the central portion of the semiconductor device to prevent collapse of the plurality of channel stack structures CSS, and the second gate structure GS2 is positioned in the space from which the support portion (see SP in FIG. 20A) has been removed.

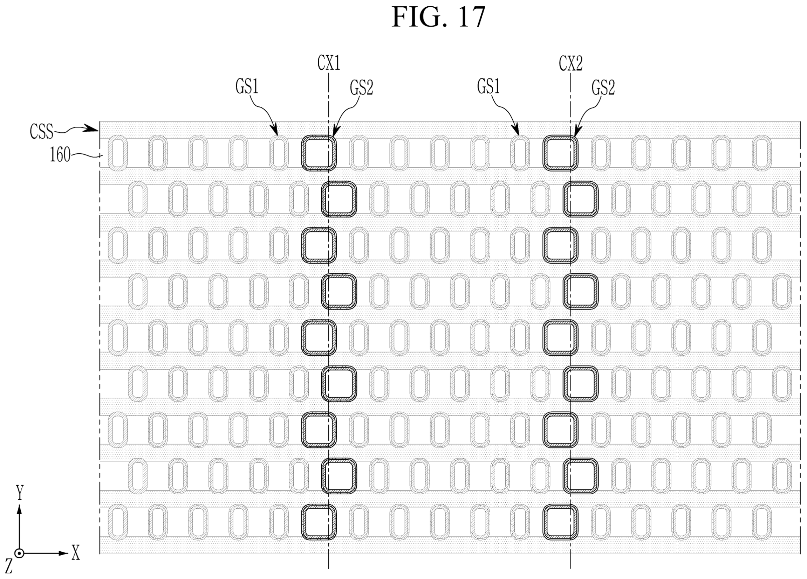

Referring to FIG. 17, the second gate structure GS2 of the semiconductor device according to some Examples may be arranged along a plurality of columns. For example, the second gate structure GS2 may be arranged along a first central axis CX1 and a second central axis CX2. Here, the first central axis CX1 and the second central axis CX2 may be reference axes extending in the second direction (Y direction) that are positioned at equal intervals within the semiconductor device. Accordingly, the second gate structure GS2 may be arranged at equal intervals in the first direction (X direction), and thus, in the process of manufacturing the semiconductor device, it is possible to effectively prevent the collapse of the plurality of channel stack structures CSS. However, the number of central axes may be variously changed.

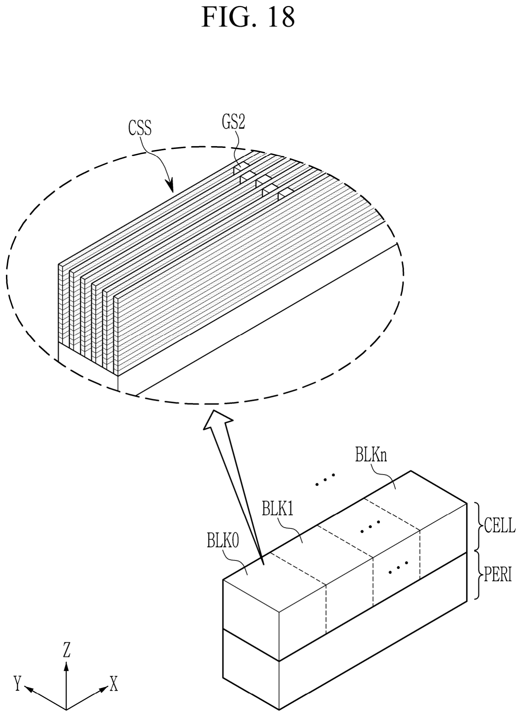

Hereinafter, a semiconductor device according to examples will be described with reference to FIG. 18.

FIG. 18 is a perspective view showing a semiconductor device according to examples.

Referring to FIG. 18, the semiconductor device may include a peripheral circuit region PERI and a memory cell region CELL. The memory cell region CELL may be stacked on the peripheral circuit region PERI. The peripheral circuit region PERI and the memory cell region CELL may be overlapped in a planar perspective (e.g., overlapped with each other in the third direction (Z direction)).

The memory cell region CELL may include a plurality of memory blocks BLK0-BLKn, where n is a positive integer which are units for data erasure. Each of the memory blocks BLK0-BLKn may include a cell array having a three-dimensional structure (or vertical structure).

The cell array may include a plurality of cell transistors constituting a plurality of memory cells arranged three-dimensionally as described in FIGS. 1 to 17, a plurality of word lines (see WL in FIG. 28) electrically connected to the plurality of cell transistors, and a plurality of bit lines (see BL in FIG. 28). The peripheral circuit region PERI may include a control circuit for controlling the memory blocks BLK0-BLKn.

According to one example, the second gate electrode 142 of the second gate structure GS2 may be a memory gate electrode forming a plurality of memory cells. In this case, a second memory gate voltage for driving the memory cell may be applied to the second gate electrode 142, and a first memory gate voltage for driving the memory cell may be applied to the first gate electrode 141. Since the contact area between the second gate structure GS2 and the plurality of channel stack structures CSS is greater than the contact area between the first gate structure GS1 and the plurality of channel stack structures CSS, the second memory gate voltage may be smaller than the first memory gate voltage in order for the memory cell to operate uniformly by the first gate structure GS1 and the second gate structure GS2. However, this is not limited thereto, and the second memory gate voltage may be substantially equal to or greater than the first memory gate voltage. The semiconductor device may comprise a voltage driver (e.g., a voltage generation circuit) configured to generate the first and second memory gate voltages and provide the first and second memory gate voltages to the first and second gate electrodes 141 and 142. The voltage driver may form part of a decoder (e.g., the decoder circuit 1110 of FIG. 28).

In another example, the second gate electrode 142 of the second gate structure GS2 may be a dummy gate electrode. When the second gate electrode 142 is a dummy gate electrode, a dummy voltage for driving the memory cell may be applied to the second gate electrode 142. For example, the same dummy voltage may be applied to the second gate electrode 142 positioned in each of the memory blocks BLK0-BLKn, but example embodiments are not limited thereto. The first gate electrode 141 of the first gate structure GS1 positioned at each of the memory blocks BLK0-BLKn may have different signals applied thereto, but example embodiments are not limited thereto.

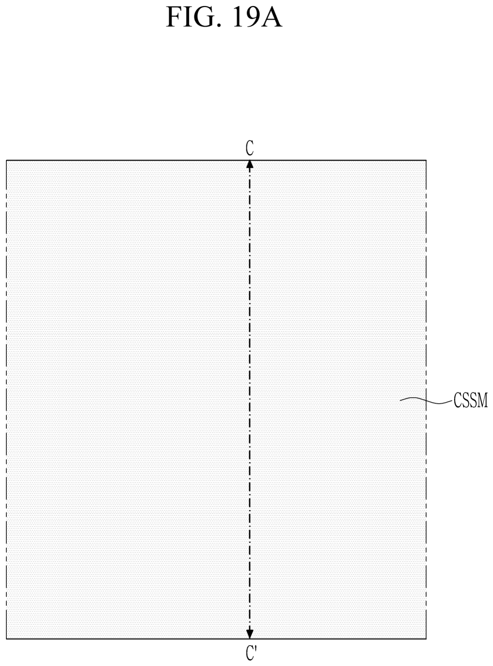

Hereinafter, a method of manufacturing a semiconductor device according to examples will be described with reference to FIGS. 19A to 23C.

FIGS. 19A, 19B, 20A to 20E, 21, 22, and 23A to 23C are drawings of intermediate steps illustrating a method of manufacturing a semiconductor device according to examples. Hereinafter, the same configuration as previously described will be referred to by the same reference numeral, redundant description will be omitted or simplified, and the differences will be mainly described.

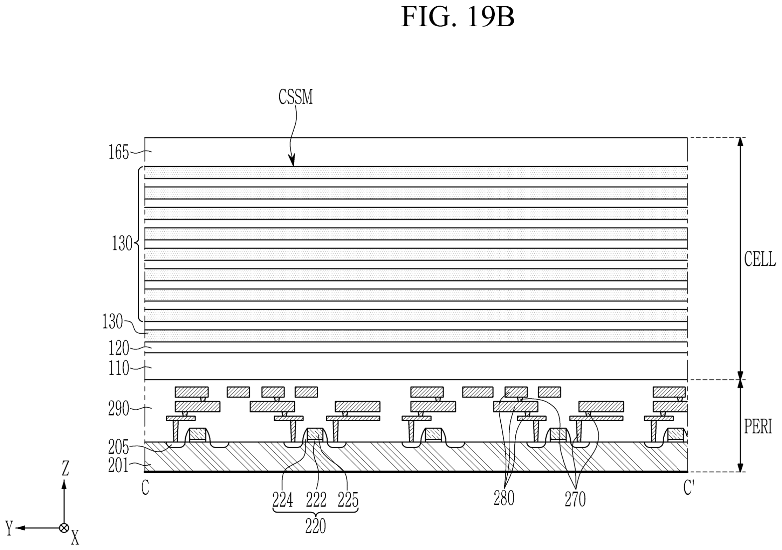

Referring to FIGS. 19A and 19B, a preliminary stack structure CSSM may be formed by alternately stacking a plurality of interlayer insulating layers 120 and a plurality of channel layers 130 on the substrate 110. Also, a cell region insulating layer 165 may be formed on the preliminary stack structure CSSM.

In this case, the substrate 110 may be positioned on the peripheral circuit region PERI. The peripheral circuit region PERI may include a main substrate 201, circuit elements 220 positioned on the main substrate 201, circuit contact plugs 270, and circuit wiring lines 280.

Referring to FIGS. 20A to 20E, a separation trench ST extending in the first direction (X direction) and penetrating the preliminary stack structure CSSM may be formed to form a support portion SP. For example, a plurality of separation trenches ST may be formed.

Each separation trench ST may penetrate the cell region insulating layer 165 and the preliminary stack structure CSSM. The separation trenches ST may be arranged spaced apart from each other in the second direction (Y direction). The separation trenches may be spaced apart from each other in the first direction (X direction) and the second direction (Y direction). Each separation trench ST may extend in the first direction (X direction) and the third direction (Z direction). The separation trenches ST may be arranged in one or more rows in the first direction (X direction). Separation trenches ST in one row may be separated from each other by one or more support portions SP. Separation trenches in adjacent rows in the second direction (Y direction) may be separated from each other by channel stack structures CSS. The separation trenches ST may each extend in the first direction (X direction). For example, one or more separation trenches ST may extend from the edge of the semiconductor device in the first direction (X direction). The separation trenches ST may not be formed in the central portion of the semiconductor device (e.g., where the support portions SP are formed). As the separation trenches ST are formed, a plurality of channel stack structures CSS extending in the first direction (X direction) and arranged in the second direction (Y direction) may be formed. The inner walls of the separation trenches ST may be defined by the plurality of channel stack structures CSS. A bottom surface of each separation trench ST may be defined by the substrate 110.

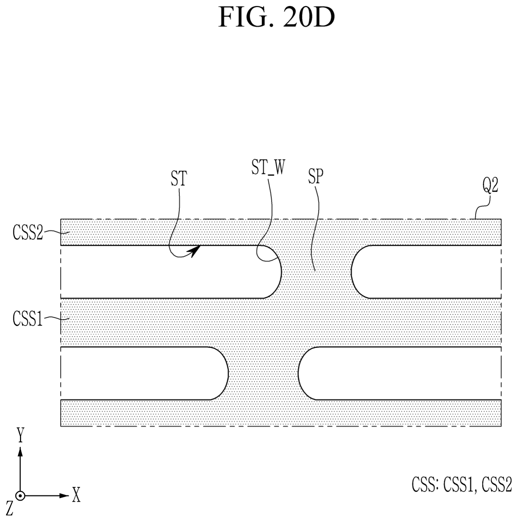

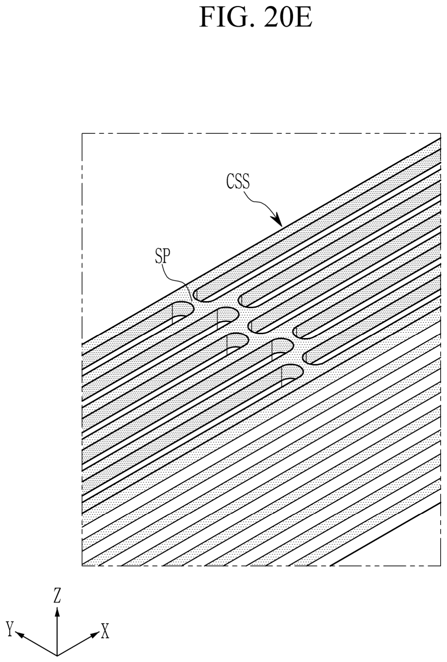

As illustrated in FIG. 20D and FIG. 20E, the inner sidewall ST_W of the separation trench ST may include a curved surface in a plan view. The inner sidewall ST_W of the separation trench ST may have a curved shape that is convex toward the support portion SP.

Since the separation trenches ST are not formed in the central portion of the semiconductor device, a support portion SP may be formed between separation trenches ST adjacent to each other in the first direction (X direction). The support portion SP may be positioned at the central portion of the semiconductor device. The support portion SP may be positioned between the plurality of channel stack structures CSS adjacent to each other in the second direction (Y direction). The support portion SP may be integrally formed with the plurality of channel stack structures CSS. The support portion SP may define an inner sidewall ST_W of the separation trench ST. As shown in 20C, the support portion SP may have an inclined side surface narrowing toward the substrate 110 according to the aspect ratio. For example, the width at an upper portion of the support portion SP in the second direction (Y direction) may be smaller than the width at a lower portion of the support portion SP in the second direction (Y direction), but example embodiments are not limited thereto. A plurality of support portions SP may be arranged, spaced apart from each other in the second direction (Y direction). Each support portion SP may be between a corresponding pair of adjacent channel stack structures CSS in the second direction (Y direction). Each support portion SP may be connected to and may support the corresponding pair of adjacent channel stack structures CSS. Each support portion SP may be between a corresponding pair of adjacent separation trenches ST in the first direction (X direction).

According to one Example, the support portion SP may prevent a plurality of channel stack structures CSS from collapsing in the second direction (Y direction). Specifically, a plurality of channel stack structures CSS may be spaced apart and arranged in the second direction (Y direction) by the separation trench ST. In this case, since the length of the plurality of channel stack structures CSS in the first direction (X direction) is significantly greater than the width of the plurality of channel stack structures CSS in the second direction (Y direction), there may occur a problem in which the plurality of channel stack structures CSS are inclined or collapse in the second direction (Y direction). The degree to which the plurality of channel stack structures CSS tilt or collapse in the second direction (Y direction) may depend on bending stress in the second direction (Y direction), and the bending stress may depend on the extension length of the separation trench ST in the first direction (X direction). In a Comparative Example, when the support portion SP is not formed, the separation trench ST may extend in the first direction (X direction) over the entire semiconductor device, and the bending stress according to the second direction (Y direction) of the plurality of channel stack structures CSS may be relatively reduced. A semiconductor device according to one example may reduce an extension length of the separation trench ST in the first direction (X direction) by forming a support portion SP at a central portion. Accordingly, the bending stress of the plurality of channel stack structures CSS in the second direction (Y direction) may be relatively increased, and it may be possible to prevent the plurality of channel stack structures CSS from bending or collapsing in the second direction (Y direction).

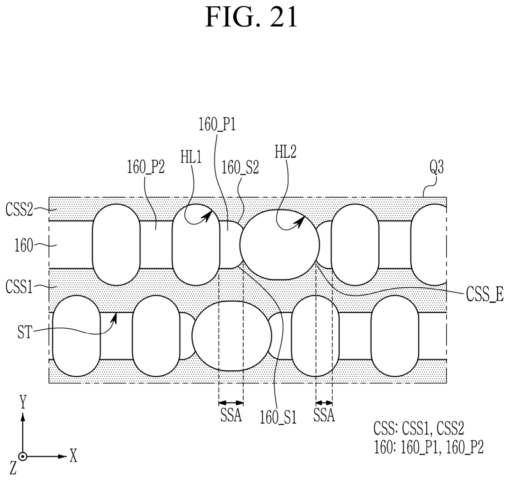

Referring to FIG. 21, a separation insulating layer 160 may be formed in the separation trench ST. In addition, a first hole HL1 penetrating the separation insulating layer 160 may be formed, and a second hole HL2 penetrating the support portion SP may be formed.

The first hole HL1 may be formed by etching the separation insulating layer 160. A plurality of first holes HL1 may be formed. The first holes HL1 may be arranged spaced apart in the first direction (X direction). The first holes HL1 may be arranged spaced apart in the second direction (Y direction). The first holes HL1 may be arranged in a zigzag pattern of a lattice pattern in a first diagonal direction intersecting the first direction (X direction) and the second direction (Y direction). One or more first holes HL1 may be formed within each separation trench ST. For example, first holes HL1 may be spaced apart and arranged in the first direction (X direction) within one separation trench ST extending in the first direction (X direction). For example, within each separation trench ST, a plurality of first holes HL1 may be formed, spaced apart and arranged in the first direction (X direction) (e.g., in a row).

A second hole HL2 may be formed by etching the plurality of channel layers 130 and the plurality of interlayer insulating layers 120 constituting the support portion SP. In addition, the second hole HL2 may be formed by etching at least a portion of the separation insulating layer 160 together (e.g., a portion of the separation insulating layer 160 that is adjacent to the support portion SP). A plurality of second holes HL2 may be formed. For example, each of the support portions SP may be etched for form corresponding second holes HL2. Each second hole HL2 may be defined by the side surface of the separation insulating layer 160 and the side surfaces of the plurality of channel stack structures CSS. For example, the second hole HL2 may be defined by the side surface of the separation insulating layer 160, the side surface of the first channel stack structure CSS1, and the side surface of the second channel stack structure CSS2. Here, the first channel stack structure CSS1 and the second channel stack structure CSS2 refer to a plurality of channel stack structures CSS positioned adjacent to each other in the second direction (Y direction).

The second holes HL2 may be arranged in a zigzag pattern in a first diagonal direction intersecting the first direction (X direction) and the second direction (Y direction). Each second hole HL2 may be positioned between first holes HL1 adjacent to each other in the first direction (X direction). The second holes HL2 may be formed such that the plurality of channel stack structures CSS are spaced apart in the second direction (Y direction). A plurality of channel stack structures CSS may be spaced apart from each other in the second direction (Y direction) by the second hole(s) HL2. For this purpose, the width of the second holes HL2 in the first direction (X direction) may be greater than the width of the first holes HL1 in the first direction (X direction). In the process of forming the first holes HL1 and the second holes HL2, at least a portion of the plurality of channel stack structures CSS may be etched together.

According to the example, the second holes HL2 and the first holes HL1 may be formed simultaneously in the same process. For example, the second holes HL2 and the first holes HL1 may be patterned simultaneously by using a mask including openings corresponding to the second holes HL2 and the first holes HL1, but the present invention is not limited thereto. As another example, the second holes HL2 and the first holes HL1 may be patterned in different processes.

According to the example, the separation insulating layer 160 of the semiconductor device may include a first portion 160_P1 positioned between a first hole HL1 and a second hole HL2. The first portion 160_P1 may be positioned on opposite sides of the second hole HL2 in the first direction (X direction).

The first portion 160_P1 may include a portion having a width decreasing in the second direction (Y direction). That is, a portion in which the width of the first portion 160_P1 in the second direction (Y direction) decreases as a distance from the first hole HL1 increases. For example, the width in the second direction (Y direction) of the first portion 160_P1 adjacent to the first hole HL1 may be greater than the width in the second direction (Y direction) of the first portion 160_P1 adjacent to the second hole HL2.

The first portion 160_P1 may include side surfaces 160_S1, 160_S2 in contact with the plurality of channel stack structures CSS in a plan view. For example, the first portion 160_P1 may include a first side surface 160_S1 in contact with the first channel stack structure CSS1 and a second side surface 160_S2 in contact with the second channel stack structure CSS2 in a plan view.

The first side surface 160_S1 and the second side surface 160_S2 of the first portion 160_P1 may include a curved surface in a plan view. For example, the first side surface 160_S1 of the first portion 160_P1 may include a convex curved surface toward the first channel stack structure CSS1 in a plan view. The second side surface 160_S2 of the first portion 160_P1 may include a convex curved surface toward the second channel stack structure CSS2 in a plan view. This may be due to a process characteristic of forming a separation trench ST so that a support portion SP is formed between the plurality of channel stack structures CSS adjacent to each other in the second direction (Y direction) in order to prevent the collapse of the plurality of channel stack structures CSS. Here, the second channel stack structure CSS2 refers to a channel stack structure adjacent to the first channel stack structure CSS1 in the second direction (Y direction).

The separation insulating layer 160 of the semiconductor device according to examples may further include a second portion 160_P2 positioned between first holes HL1 adjacent to each other in the first direction (X direction). The side surface of the second portion 160_P2 may not include a curved surface in a plan view. For example, the side surface of the second portion 160_P2 be straight in a plan view (e.g., may run parallel to the first direction (X direction)).

Accordingly, a side surface CSS_S of a plurality of channel stack structures CSS of a semiconductor device according to examples may include a curved shape. For example, a side surface of the first channel stack structure CSS1 in contact with the first portion 160_P1 may include a concave curved shape. That is, in the support region SSA between the second hole HL2 and the first hole HL1, a side surface of the first channel stack structure CSS1 may include a concave curved shape. Therefore, the distance in the second direction (Y direction) between the second channel stack structure CSS2 and the first channel stack structure CSS1 in a region adjacent to the second hole HL2 may be smaller than the distance in the second direction (Y direction) between the second channel stack structure CSS2 and the first channel stack structure CSS1 in a region adjacent to the first hole HL1. This is because a side surface of the plurality of channel stack structures CSS defined by the separation trench ST has a complementary shape to a side surface of the separation insulating layer 160 filling the separation trench ST.

A plurality of channel stack structures CSS of a semiconductor device according to one example may include a protrusion portion CSS_E indented into a space between a first portion 160_P1 and a second hole HL2. The protrusion portion CSS_E is positioned in a space between the first portion 160_P1 and the second gate structure GS2, and refers to a portion of a plurality of channel stack structures CSS having a side surface with a curved shape in a plan view. The protrusion portion CSS_E may be at least a portion of the support portion SP remaining after removal by the second hole HL2. The protrusion portion CSS_E may be spaced apart from the first gate structure GS1, and may contact the second gate structure GS2.

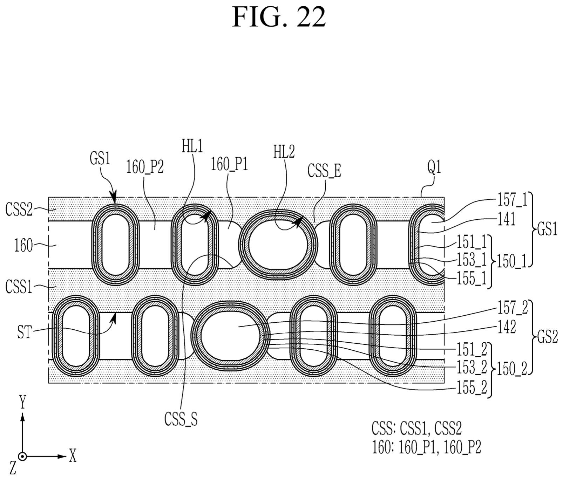

Referring to FIG. 22, a first gate structure GS1 may be formed in the first hole HL1, and a second gate structure GS2 may be formed in the second hole HL2.

The first gate dielectric layer 150_1, the first gate electrode 141, and the first core insulating layer 157_1 may be sequentially formed in the first hole HL1. First, a first gate dielectric layer 150_1 may be formed by sequentially forming a first tunneling layer 155_1, a first charge storage layer 153_1, and a first blocking layer 151_1 in the first hole HL1. Subsequently, the first gate electrode 141 may be formed in the first hole HL1, and the first core insulating layer 157_1 may be formed in the first hole HL1 to form the first gate structure GS1.

In addition, a second gate dielectric layer 150_2, a second gate electrode 142, and a second core insulating layer 157_2 may be sequentially formed in the second hole HL2. First, a second tunneling layer 155_2, a second charge storage layer 153_2, and a second blocking layer 151_2 may be sequentially formed in the second hole HL2 to form a second gate dielectric layer 150_2. Subsequently, a second gate electrode 142 may be formed in the second hole HL2, and a second core insulating layer 157_2 may be formed in the second hole HL2 to form a second gate structure GS2. The second gate dielectric layer 150_2 may be formed simultaneously with the first gate dielectric layer 150_1 in the same process. The second gate electrode 142 may be formed simultaneously with the first gate electrode 141 in the same process. The second core insulating layer 157_2 may be formed simultaneously with the first core insulating layer 157_1 in the same process.

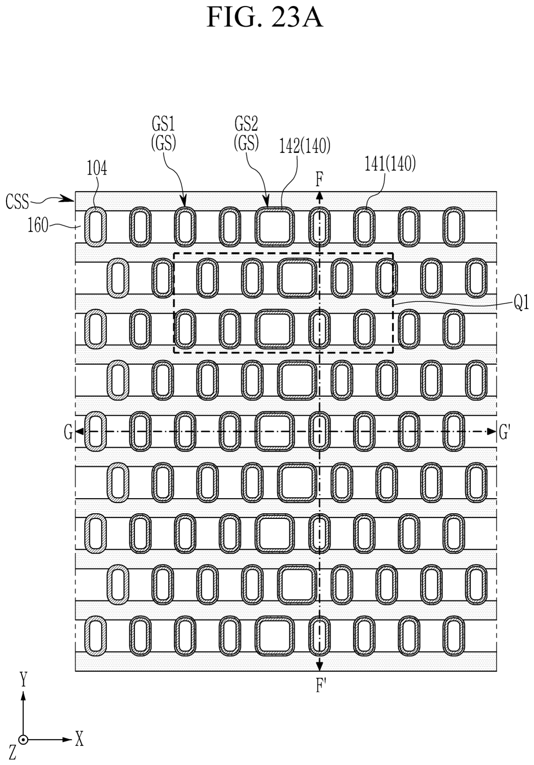

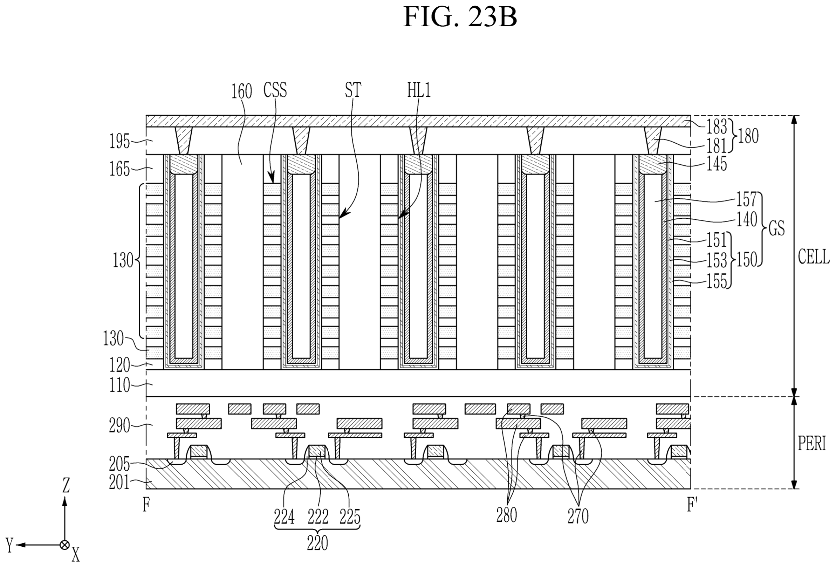

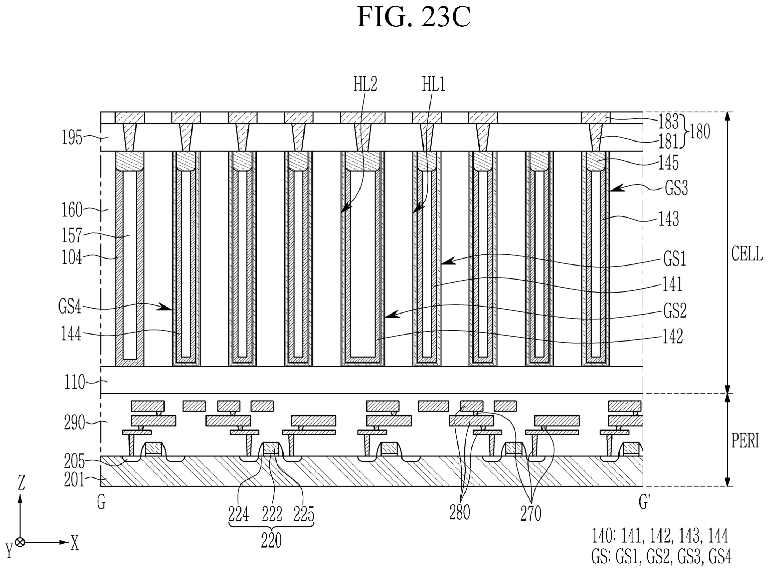

Referring to FIGS. 23A to 23C, a gate pad 145 may be formed on the (e.g., on each) first gate structure GS1 and the (e.g., on each) second gate structure GS2, and an upper insulating layer may be formed on the first gate structure GS1, the second gate structure GS2, the separation insulating layer 160, and the cell region insulating layer 165. Next, a contact plug 181 connected to the (e.g., to each) gate pad 145 is formed through the upper insulating layer 195, and an upper wiring 183 is formed on the upper insulating layer 195, thereby a semiconductor device according to one example may be formed.

Hereinafter, a method of manufacturing a semiconductor device according to examples will be described with reference to FIGS. 24 to 27.

FIGS. 24 to 27 are process plan views of intermediate steps illustrating a method of manufacturing a semiconductor device according to the example of FIG. 11. Hereinafter, the same components as previously described are referred to by the same reference numerals, redundant descriptions are omitted or simplified, and differences are mainly described.

Referring to FIG. 24, a preliminary stack structure CSSM may be formed by alternately stacking a plurality of interlayer insulating layers 120 and a plurality of channel layers 130 on the substrate 110, and a cell region insulating layer 165 may be formed on the preliminary stack structure CSSM. Next, separation trenches ST penetrating the preliminary stack structure CSSM may be formed to form one or more support portions SP. Subsequently, a separation insulating layer 160 may be formed in the separation trench ST.

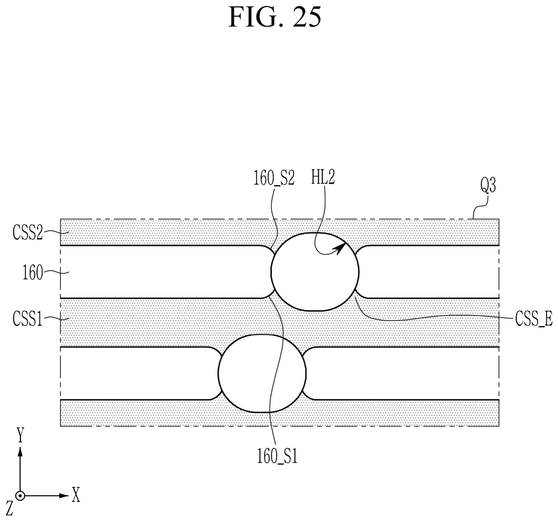

Referring to FIG. 25, a second hole HL2 penetrating the (e.g., each) support portion SP may be formed. A second hole HL2 may be formed by etching the plurality of channel layers 130 and the plurality of interlayer insulating layers 120 constituting the support portion SP. The process of patterning the second hole HL2 may include forming the second hole HL2 by using a mask including openings exposing the support portion SP. In this case, at least a portion of the separation insulating layer 160 and at least a portion of the plurality of channel stack structures CSS may be etched together. The second hole HL2 may be defined by the side surface of the separation insulating layer 160 and the side surface of the plurality of channel stack structures CSS. For example, the second hole HL2 may be defined by the side surface of the separation insulating layer 160, the side surface of the first channel stack structure CSS1, and the side surface of the second channel stack structure. Here, the first channel stack structure CSS1 and the second channel stack structure CSS2 refer to a plurality of channel stack structures CSS positioned adjacent in the second direction (Y direction).

A plurality of second holes HL2 may be formed. The second holes HL2 may be arranged in a zigzag pattern in the first diagonal direction intersecting the first direction (X direction) and the second direction (Y direction). The second hole(s) HL2 may be formed such that the plurality of channel stack structures CSS are spaced apart in the second direction (Y direction). A plurality of channel stack structures CSS may be spaced apart from each other in the second direction (Y direction) by one or more second holes HL2.

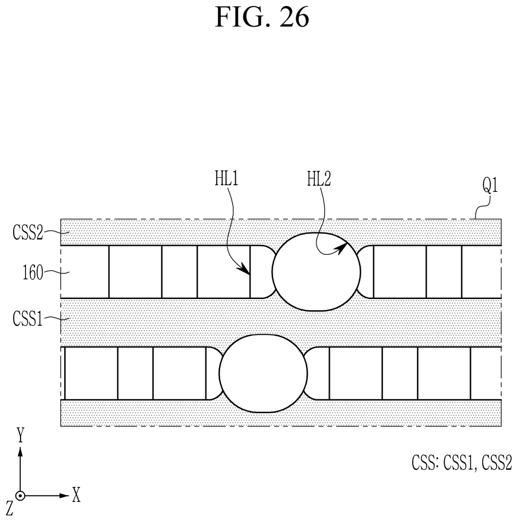

Referring to FIG. 26, one or more first holes HL1 penetrating the separation insulating layer 160 may be formed. One or more first holes HL1 may be formed adjacent to the (e.g., a corresponding) second hole HL2 in the first direction (X direction). For example, a plurality of first holes HL1 may be formed. The second hole HL2 may be positioned between adjacent first holes HL1 in the first direction (X direction). A process of forming the first hole HL1 may include etching a portion of the separation insulating layer 160 exposed by using a mask including openings corresponding to the first holes HL1, thereby forming the first holes HL1. In this case, the separation insulating layer 160 may be etched using an etching solution or etching gas having an etching selectivity with respect to the plurality of channel stack structures CSS. Accordingly, in the process of forming the first holes HL1, the plurality of channel stack structures CSS may be hardly etched (or may be not etched). Therefore, the width of the first holes HL1 in the second direction (Y direction) may be substantially equal to the width of the separation insulating layer 160 in the second direction (Y direction). The first holes HL1 may be non-overlapping with the plurality of channel stack structures CSS in the first direction (X direction).

After the formation of the second hole(s) HL2, the first hole(s) HL1, so that the first hole(s) HL1 may have a different shape from the second hole(s) HL2. For example, each first hole HL1 may have a quadrilateral shape, and each second hole HL2 may have a rounded quadrilateral shape in a plan view. An area of the first hole HL1 may be smaller than an area of the second hole HL2 in a plan view.

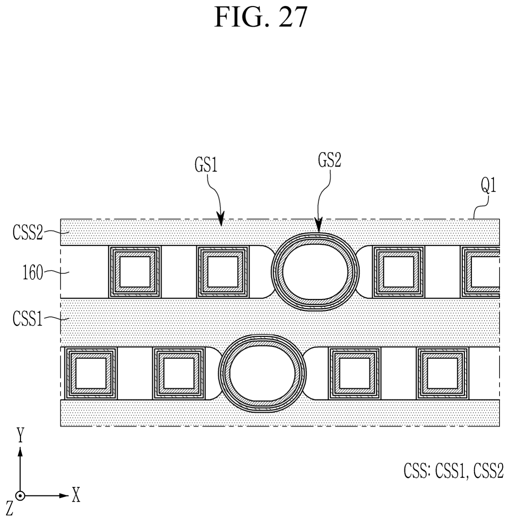

Referring to FIG. 27, the first gate structure GS1 may be formed in the first hole HL1, and the second gate structure GS2 may be formed in the second hole HL2, thereby forming a semiconductor device according to the example of FIG. 11.

Hereinafter, examples of an electronic system including the semiconductor device as described above will be described in detail with reference to FIGS. 28 to 31.

FIG. 28 is a schematic diagram showing an electronic system including a semiconductor device according to some Examples.

Referring to FIG. 28, in some examples, an electronic system 1000 may include a semiconductor device 1100 and a controller 1200 electrically connected to the semiconductor device 1100. The electronic system 1000 may be a storage device including one or a plurality of semiconductor devices 1100, or an electronic device including the storage device. For example, the electronic system 1000 may be a solid state drive device including one or a plurality of semiconductor devices 1100, a USB (Universal Serial Bus), a computing system, a medical device, or a communication device.

The semiconductor device 1100 may be a nonvolatile memory device and, for example, may be a NAND flash memory device described with reference to FIGS. 1 to 18. The semiconductor device 1100 may include a first structure 1100F and a second structure 1100S positioned on the first structure 1100F. In some examples, the first structure 1100F may be positioned next to the second structure 1100S. The first structure 1100F may be a peripheral circuit structure including a decoder circuit 1110, a page buffer 1120, and a logic circuit 1130. The second structure 1100S may be a memory cell structure including bit lines BL, a common source line CSL, word lines WL, first and second gate lines LL1, LL2, third and fourth gate lines UL1, UL2, and memory cell strings CSTR between the bit lines BL and the common source lines CSL.

In the second structure 1100S, each memory cell string CSTR may include one or more first transistors LT1, LT2 adjacent to the common source line CSL, one or more second transistors UT1, UT2 adjacent to the bit line BL, and a plurality of memory cell transistors MCT positioned between the one or more first transistors LT1, LT2 and the one or more second transistors UT1, UT2. The number of the first transistors LT1, LT2 and the number of the second transistors UT1, UT2 may be variously modified according to the example. The number of first, second, third and fourth gate lines LL1, LL2, LL3 and LL4 may be varied, corresponding to the number of first and second transistors, LT1, LT2, UT1 and UT2.

In some examples, the one or more first transistors LT1, LT2 may include a ground selection transistor, and the one or more second transistors UT1, UT2 may include a string selection transistor. The first and second gate lines LL1, LL2 may each be gate electrodes of the first transistors LT1 and LT2, respectively. Each word line WL may be the gate electrode of a corresponding memory cell transistor MCT, and the third and fourth gate lines UL1, UL2 may respectively be the gate electrodes of the second transistors UT1, UT2.

Each memory cell string CSTR may be formed from a corresponding channel layer 130 within a corresponding channel stack structure CSS extending in the first direction (X direction) (see FIG. 1). Each memory cell string CSTR may be connected to a corresponding bit line BL. The bit lines BL may be connected to different channel layers 130 in a connection region. The connection region may comprise a staircase structure. The channel layers 130 may extend further along the first direction (X direction) as the channel stack structure CSS descends (e.g., extends towards the substate 110). Accordingly, each bit line BL may be connected to a channel layer 130 at a respective level. For instance, each bit line BL may be connected to a pad structure that is electrically connected to the channel layer 130.

The common source line CSL, the first and second gate lines LL1, LL2, the word lines WL, and the first, second, third, and fourth gate lines UL1, UL2 may be electrically connected to the decoder circuit 1110 through the first connection wiring 1115 extending from the first structure 1100F to the second structure 1100S within the first structure 1100F. The decoder circuit 1110 may be configured to generate and supply gate voltages to be applied to the memory cell structure. For instance, the decoder circuit 1110 may be configured to generate and supply gate voltages to be applied to the gates within the memory cell structure (e.g., via the first and second gate lines LL1, LL2, the word lines WL, and the first, second, third, and fourth gate lines UL1, UL2). The bit lines BL may be electrically connected to the page buffer 1120 through a second connection wiring 1125 extending from the first structure 1100F to the second structure 1100S within the first structure 1100F.

In the first structure 1100F, the decoder circuit 1110 and the page buffer 1120 may perform a control operation for at least one memory cell transistor selected from among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pad 1101 may be electrically connected to the logic circuit 1130 through input/output connection wiring 1135 extending from the first structure 1100F to the second structure 1100S within the first structure 1100F.

The controller 1200 may include a processor 1210, a NAND controller 1220, and a host interface 1230. According to examples, an electronic system 1000 may include a plurality of semiconductor devices 1100, and in this case, a controller 1200 may control the plurality of semiconductor devices 1100.

The processor 1210 may control the operation of the entire electronic system 1000 including the controller 1200. The processor 1210 may operate according to predetermined firmware, and may control the NAND controller 1220 to access the semiconductor device 1100. The NAND controller 1220 may include a NAND interface 1221 for processing communication with the semiconductor device 1100. Through the NAND interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the electronic system 1000 and an external host. When a control command is received from an external host through the host interface 1230, the processor 1210 may control the semiconductor device 1100 in response to the control command.

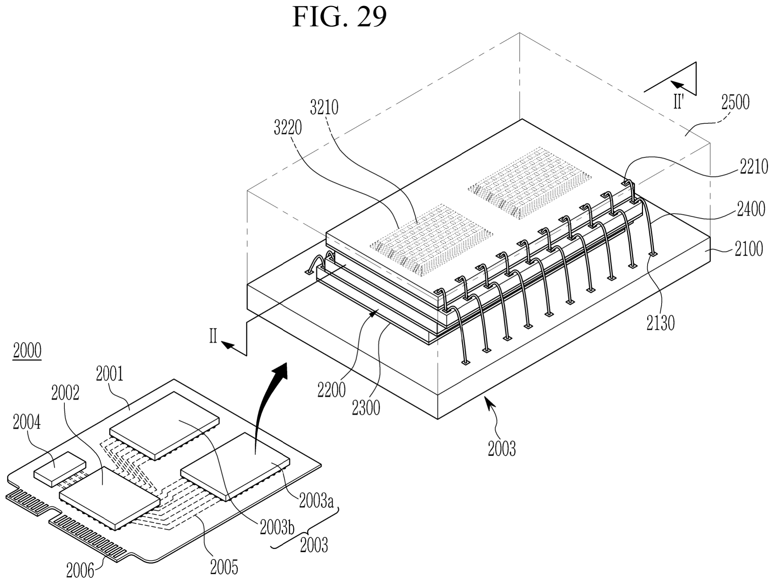

FIG. 29 is a perspective view schematically illustrating an electronic system including a semiconductor device according to some Examples.

Referring to FIG. 29, an electronic system 2000 according to some Examples may include a main substrate 2001, a controller 2002 mounted on the main substrate 2001, one or more semiconductor packages 2003, and a DRAM 2004. A semiconductor package 2003 and a DRAM 2004 may be connected to each other and to a controller 2002 by a wiring pattern 2005 formed on a main substrate 2001.

The main substrate 2001 may include a connector 2006 including a plurality of pins coupled to an external host. In the connector 2006, the number and arrangement of the plurality of pins may vary according to a communication interface between the electronic system 2000 and the external host. In some examples, the electronic system 2000 may communicate with an external host according to any one of interfaces such as USB (Universal Serial Bus), PCI-Express (Peripheral Component Interconnect Express), SATA (Serial Advanced Technology Attachment), or M-Phy for UFS (Universal Flash Storage). In some examples, the electronic system 2000 may operate by power supplied from an external host through the connector 2006. The electronic system 2000 may further include a PMIC (Power Management Integrated Circuit) for distributing power supplied from the external host to the controller 2002 and the semiconductor package 2003.

The controller 2002 may record data in the semiconductor package 2003, or may read data from the semiconductor package 2003, and may improve an operation speed of the electronic system 2000.

The DRAM 2004 may be buffer memory for alleviating speed differences between a semiconductor package 2003, which is a data storage space, and an external host. The DRAM 2004 included in the electronic system 2000 may also operate as a kind of cache memory, and may provide space for temporarily storing data in control operations for the semiconductor package 2003. In cases where the electronic system 2000 includes DRAM 2004, the controller 2002 may further include a DRAM controller for controlling the DRAM 2004, in addition to the NAND controller for controlling the semiconductor package 2003.

The semiconductor package 2003 may include first and second semiconductor packages 2003a, 2003b spaced apart from each other. The first and second semiconductor packages 2003a, 2003b may each be a semiconductor package including a plurality of semiconductor chips 2200. Each of the first and second semiconductor packages 2003a, 2003b may include a package substrate 2100, a semiconductor chip 2200 on the package substrate 2100, an adhesive layer 2300 disposed on a lower surface of each semiconductor chip 2200, a connection structure 2400 electrically connecting the semiconductor chip 2200 and the package substrate 2100, and a molding layer 2500 covering the semiconductor chip 2200 and the connection structure 2400 on the package substrate 2100.

The package substrate 2100 may be a printed circuit substrate including the package upper pad 2130. Each semiconductor chip 2200 may include an input/output pad 2210. The input/output pad 2210 may correspond to the input/output pad 1101 of FIG. 28. Each semiconductor chip 2200 may include a channel stack structure 3210 and a plurality of gate structures 3220. The semiconductor chip 2200 may include the semiconductor device described with reference to FIGS. 1 to 17.

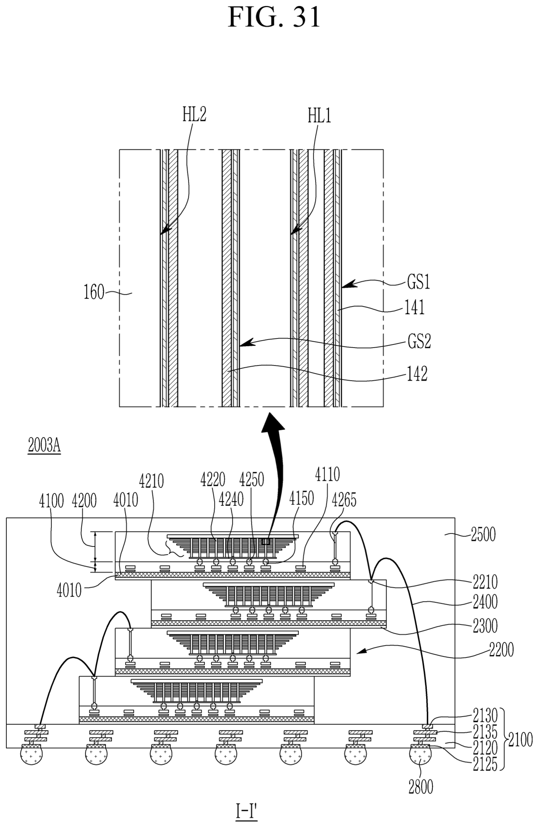

FIGS. 30 and 31 are cross-sectional views schematically illustrating a semiconductor package according to some examples.

Referring to FIG. 30, in the semiconductor package 2003, the package substrate 2100 may be a printed circuit substrate. The package substrate 2100 may include a package substrate body portion 2120, a package upper pad 2130 positioned on an upper surface of the package substrate body portion 2120, a lower pad 2125 positioned on a lower surface of the package substrate body portion 2120 or exposed through the lower surface, and an inner wiring 2135 electrically connecting the upper pad 2130 and the lower pad 2125 inside the package substrate body portion 2120. The upper pad 2130 may be electrically connected to the connection structure 2400. The lower pad 2125 may be connected to the wiring pattern 2005 of the main substrate 2010 of the electronic system 2000 as shown in FIG. 29 via the conductive connection portion 2800.

The semiconductor chip 2200 may include a first structure 3100 and a second structure 3200 which are sequentially stacked on each semiconductor substrate 3010 and substrate 3010, respectively. The first structure 3100 may include a peripheral circuit region including peripheral wiring 3110. The second structure 3200 may include a channel stack structure 3210, a plurality of gate structures 3220 penetrating the channel stack structure 3210, and a word line 3240 electrically connected to the plurality of gate structures 3220. The second structure 3200 may further include a bit line (see 'BL' in FIG. 28) electrically connected to the channel stack structure 3210, and a common source line (see 'CSL' in FIG. 28) electrically connected to the channel stack structure 3210.

In the method of manufacturing a semiconductor chip 2200 or a semiconductor device according to examples, a support portion (see SP in FIG. 20A) may be formed between a plurality of channel stack structures CSS adjacent in the second direction (Y direction), and, in a subsequent process, a second gate structure GS2 passing through the support portion (see SP in FIG. 20A) may be formed. Accordingly, it may be possible to prevent the collapse of the plurality of channel stack structures CSS during the process of manufacturing the semiconductor device, and defects of the semiconductor device may be prevented.

Each semiconductor chip 2200 may include a through wiring 3245 electrically connected to the peripheral wiring 3110 of the first structure 3100 and extending into the second structure 3200. The through wiring 3245 may penetrate the channel stack structure 3210, and may be further disposed outside the channel stack structure 3210. Each semiconductor chip 2200 may further include input/output connection wiring 3265 electrically connected to the peripheral wiring 3110 of the first structure 3100 and extending into the second structure 3200, and an input/output pad 2210 electrically connected to the input/output connection wiring 3265.

In some examples, in the semiconductor package 2003, a plurality of semiconductor chips 2200 may be electrically connected to each other by a connection structure 2400 in the form of bonding wires. As another example, a plurality of semiconductor chips 2200 or a plurality of portions constituting the same may be electrically connected by a connection structure including a through silicon via.

Referring to FIG. 31, in the semiconductor package 2003A, each semiconductor chip 2200a may include a semiconductor substrate 4010, a first structure 4100 on the semiconductor substrate 4010, and a second structure 4200 including a wafer bonding type joined to the first structure 4100 on the first structure 4100.

The first structure 4100 may include a peripheral circuit region including peripheral wiring 4110 and a first junction structure 4150. The second structure 4200 may include a channel stack structure 4210, a plurality of gate structures 4220 penetrating the channel stack structure 4210, and a word line 4240 electrically connected to the plurality of gate structures 4220. The second structure 4200 may further include a bit line (see 'BL' of FIG. 28) electrically connected to the channel stack structure 4210, a second junction structure 4250 electrically connected to the bit line (see 'BL' of FIG. 28), and a common source line see 'CSL' of FIG. 28 electrically connected to the channel stack structure 4210. For example, the second junction structure 4250 may be electrically connected to the plurality of gate structures 4220 through a gate connection wiring that is electrically connected to the word line 4240 and the plurality of gate structures 4220. The first junction structure 4150 of the first structure 4100 and the second junction structure 4250 of the second structure 4200 may be bonded while contacting each other. The joined portion of the first junction structure 4150 and the second junction structure 4250 may, for example, be formed of copper (Cu).

In the method of manufacturing a semiconductor chip 2200 or a semiconductor device according to examples, a support portion (see SP in FIG. 20A) may be formed between a plurality of channel stack structures CSS adjacent in the second direction (Y direction), and in a subsequent process, a second gate structure GS2 penetrating the support portion (see SP in FIG. 20A) may be formed. Accordingly, in the process of manufacturing the semiconductor device, it may be possible to prevent the collapse of the plurality of channel stack structures CSS, and defects of the semiconductor device may be prevented.

Each semiconductor chip 2200a may further include an input/output pad 2210 and input/output connection wiring 4265 under the input/output pad 2210. The input/output connection wiring 4265 may be electrically connected with a portion of the second junction structure 4250.

In one example, in a semiconductor package 2003, a plurality of semiconductor chips 2200 may be electrically connected to each other by a connection structure 2400 in the form of a bonding wire. In another example, the plurality of portions constituting the plurality of semiconductor chips 2200 or the plurality of semiconductor chips 2200 may be electrically connected by a connection structure including a through silicon via.

Embodiments are set out in the following Clauses:
Clause 1. A semiconductor device comprising:
   a plurality of channel stack structures, each including a plurality of interlayer insulating layers and a plurality of channel layers alternately stacked, the plurality of channel stack structures positioned spaced apart and arranged in a first direction and extending in a second direction intersecting the first direction;
   a separation insulating layer positioned between the plurality of channel stack structures;
   a first gate structure positioned between the plurality of channel stack structures and penetrating the separation insulating layer; and
   a second gate structure positioned at one side of the first gate structure in the second direction and penetrating the separation insulating layer,
   wherein the first gate structure includes:
      a first gate electrode, and
      a first charge storage layer surrounding the first gate electrode,
      wherein the second gate structure includes:
         a second gate electrode including a same material as a material of the first gate electrode, and
         a second charge storage layer surrounding the second gate electrode and including a same material as a material of the first charge storage layer, and
         wherein a width of the separation insulating layer in a region adjacent to the first gate structure in the first direction is greater than a width of the separation insulating layer in a region adjacent to the second gate structure in the first direction.
Clause 2. The semiconductor device of Clause 1,
   wherein a portion of the side surface of the separation insulating layer positioned between the first gate structure and the second gate structure has a curved shape in a plan view.
Clause 3. The semiconductor device of Clause 1 or Clause 2,
   wherein:
   the plurality of channel stack structures includes a protrusion portion extending into a space between the separation insulating layer and the second gate structure, and
   the protrusion portion is spaced apart from the first gate structure and is in contact with the second gate structure.
Clause 4. The semiconductor device of any of Clauses 1-3,
   wherein the plurality of channel stack structures includes:
   a first channel stack structure, and
   a second channel stack structure spaced apart and positioned in the first direction from the first channel stack structure, and
   wherein a distance in the first direction between the second channel stack structure and the first channel stack structure in a region adjacent to the second gate structure is less than a distance in the first direction between the second channel stack structure and the first channel stack structure in a region adjacent to the first gate structure.
Clause 5. An electronic system comprising:
   a main substrate;
   a semiconductor device on the main substrate; and
   a controller positioned on the main substrate and electrically connected to the semiconductor device,
   wherein the semiconductor device includes:
      a peripheral circuit region,
      a cell region including input/output connection wiring electrically connected to the peripheral circuit region, and
      an input/output pad positioned in the cell region and electrically connected to the input/output connection wiring extending into the cell region,
      wherein the cell region includes:
         a plurality of channel stack structures, each including a plurality of interlayer insulating layers and a plurality of channel layers alternately stacked and spaced apart and arranged in a first direction;
         a first gate structure positioned between the plurality of channel stack structures; and
         a second gate structure positioned at one side of the first gate structure in a second direction intersecting the first direction of the first gate structure,
         wherein the first gate structure includes:
            a first gate electrode; and
            a first charge storage layer surrounding the first gate electrode,
            wherein the second gate structure includes:
               a second gate electrode including a same material as a material of the first gate electrode; and
               a second charge storage layer surrounding the second gate electrode and including a same material as a material of the first charge storage layer, and wherein a width of the second gate structure in the second direction is greater than a width of the first gate structure in the second direction.

Although the embodiments of the present invention have been described in detail above, the scope of rights of the present invention is not limited thereto, and various modifications and improved forms by those skilled in the art utilizing the fundamental concepts of the present invention defined in the following claims also belong to the scope of rights of the present invention.

## Claims

1. A semiconductor device comprising:
a plurality of channel stack structures (CSS), each including a plurality of interlayer insulating layers (120) and a plurality of channel layers (130) alternately stacked, the plurality of channel stack structures (CSS) being positioned spaced apart and arranged in a first direction;
a first gate structure (GS1) positioned between the plurality of channel stack structures (CSS); and
a second gate structure (GS2) positioned at one side of the first gate structure (GS1) in a second direction intersecting the first direction,
wherein the first gate structure (GS1) includes:
a first gate electrode (141); and
a first charge storage layer (153_1) surrounding the first gate electrode (141), and
wherein the second gate structure (GS2) includes:
a second gate electrode (142) including a same material as a material of the first gate electrode (141); and
a second charge storage layer (153_2) surrounding the second gate electrode (142) and including a same material as a material of the first charge storage layer (153_1),
wherein a width (W2) of the second gate structure (GS2) in the second direction is greater than a width (W1) of the first gate structure (GS1) in the second direction.

2. The semiconductor device of claim 1,
wherein a contact area between the plurality of channel layers (130) and the second gate structure (GS2) is greater than or equal to a contact area between the plurality of channel layers (130) and the first gate structure (GS1).

3. The semiconductor device of claim 1 or claim 2,
wherein a length (DD2) of the second gate structure (GS2) in the first direction is different from a length (DD1) of the first gate structure (GS1) in the first direction.

4. The semiconductor device of any preceding claim, further comprising:
a separation insulating layer (160) positioned between the plurality of channel stack structures (CSS), and
wherein the first gate structure (GS1) and the second gate structure (GS2) respectively penetrate the separation insulating layer (160).

5. The semiconductor device of claim 4,
wherein the separation insulating layer (160) includes a first portion (160_P1) positioned between the first gate structure (GS1) and the second gate structure (GS2), and
a side surface of the first portion (160_P1) includes a curved surface in a plan view.

6. The semiconductor device of claim 5,
wherein a width of the first portion (160_P1) in the first direction includes a portion that decreases as a distance from the first gate structure increases (GS1).

7. The semiconductor device of claim 4,
wherein:
the separation insulating layer (160) includes a first portion (160_P1) positioned between the first gate structure (GS1) and the second gate structure (GS2), and
the plurality of channel stack structures (CSS) includes a protrusion portion (CSS_E) extending into a space between the first portion (160_P1) and the second gate structure (GS2).

8. The semiconductor device of claim 7,
wherein the protrusion portion (CSS_E) is spaced apart from the first gate structure (GS1) and is in contact with the second gate structure (GS2).

9. The semiconductor device of claim 7 or claim 8,
wherein:
a side surface (E_S1) of the protrusion portion (CSS_E) has a first curvature at the first level,
a side surface (E_S2) of the protrusion portion (CSS_E) has a second curvature at a second level higher than the first level, and
the first curvature is less than the second curvature.

10. The semiconductor device of any preceding claim,
wherein a side surface of the plurality of channel stack structures (CSS) positioned in a region between the second gate structure (GS2) and the first gate structure (GS1) has a curved shape in a plan view.

11. The semiconductor device of any preceding claim,
wherein the plurality of channel stack structures (CSS) includes:
a first channel stack structure (CSS1); and
a second channel stack structure (CSS2) positioned spaced apart from the first channel stack structure (CSS1) in the first direction; and
wherein a distance between the second channel stack structure (CSS2) and the first channel stack structure (CSS1) in an area adjacent to the second gate structure (GS2) in the first direction is less than a distance between the second channel stack structure (CSS2) and the first channel stack structure (CSS1) in an area adjacent to the first gate structure (GS1) in the first direction.

12. The semiconductor device of any preceding claim,
wherein, in a plan view, the first gate structure (GS1) has a quadrilateral shape, and the second gate structure (GS2) has a rounded quadrilateral shape or an elliptical shape.

13. The semiconductor device of any preceding claim,
wherein a width (W2) of the second gate structure (GS2) in the second direction is from 1.2 times to 2 times a width (W1) of the first gate structure (GS1) in the second direction.

14. The semiconductor device of any preceding claim,
wherein:
a thickness of the first gate electrode (141) is approximately equal to a thickness of the second gate electrode (142), and
a thickness of the first charge storage layer (153_1) is approximately equal to a thickness of the second charge storage layer (153_2).

15. The semiconductor device of claim 14,
wherein the first gate structure (GS1) includes:
a first blocking layer (151_1) positioned between the first gate electrode (141) and the first charge storage layer (153_1); and
a first tunneling layer (155_1) positioned between the first charge storage layer (153_1) and the plurality of channel layers (130);
wherein the second gate structure (GS2) includes:
a second blocking layer (151_2) positioned between the second gate electrode (142) and the second charge storage layer (153_2) and including a same material as a material of the first blocking layer (151_1); and
a second tunneling layer (155_2) positioned between the second charge storage layer (153_2) and the plurality of channel layers (130) and including a same material as a material of the first tunneling layer (155_1); and
wherein:
a thickness of the first blocking layer (151_1) is approximately equal to a thickness of the second blocking layer (151_2), and
a thickness of the first tunneling layer (155_2) is approximately equal to a thickness of the second tunneling layer (155_2).
